# EUROPEAN PATENT APPLICATION

(11) **EP 4 675 396 A1**
(43) Date of publication of application: **07.01.2026**
(21) Application number: 25180731.9
(22) Date of filing: 04.06.2025
(51) Int. Cl.: G06F 1/20, H01L 23/367, H05K 1/02

(54) **HEATSINKS FOR IN-LINE MEMORY MODULES**

(30) Priority: 03.07.2024 US 202463667600 P; 02.06.2025 US 202519225654
(71) Applicant: Google LLC, Mountain View, CA 94043 (US)
(72) Inventor: TANG, Weihua, Mountain View, California, 94043 (US); KHALILI, Sadegh, Mountain View, California, 94043 (US); MUSA, Shekaib Ahmad, Mountain View, California, 94043 (US); IYENGAR, Madhusudan K., Mountain View, California, 94043 (US); BRANCH, Michael, Mountain View, California, 94043 (US)
(74) Representative: Betten & Resch

(57) **Abstract**

A system for cooling a plurality of in-line memory modules includes sliding thermal interface material ("TIM") pads and a heatsink thermally coupled to the in-line memory modules through the sliding TIM pads. The heatsink further includes a base, a plurality of thermally conductive fins, and a plurality of pedestals. The base extends in a plane. The plurality of thermally conductive fins extend in a first direction away from the base. The plurality of pedestals extend in a second direction away from the base and opposite the first direction. The sliding TIM pads are positioned between each of the plurality of pedestals and an adjacent in-line memory module. The plurality of pedestals further include a first leg and a second leg. The first and second legs are configured to move between a first position and a second position.

## Description

### CROSS-REFERENCE TO RELATED APPLICATIONS

The present application claims the benefit of the filing date of U.S. Provisional Patent Application No. 63/667,600, filed July 3, 2024, the disclosure of which is hereby incorporated herein by reference.

### BACKGROUND

As the thermal design power ("TDP") and total number of Dual In-line Memory Modules ("DIMMs") continues to increase, it has become increasingly challenging to cool DIMMs within thermal specification temperature (typically 85°C for 1x refresh). It has become even more difficult to reduce the temperature within the DIMM for reliability benefits. These same challenges are equally applicable to other types of in-line memory modules, such as Registered Dual In-line Memory Modules ("RDIMMs"), Multi-Ranked Buffered Dual In-line Memory Modules ("MRDIMMs"), and Single In-Line Memory Modules ("SIMMs").

Common cooling solutions include increasing the approaching air flow velocity, reducing the approaching air temperature for air cooling, and using liquid cooling technology. Improvements are needed to enhance both cooling and heat dissipation.

### BRIEF SUMMARY

The present technology presents several approaches to the distribution of heat in in-line memory modules. Approaches include the addition of heat spreaders and/or heatsinks, improved air distribution systems, and pseudo-tall MRDIMMs with die layout optimization to enhance cooling efficiency without increasing air flow velocity or reducing air inlet temperature. These features can be used standing alone or in combination with one or more other features. The proposed features balance field serviceability, manufacturing feasibility, and cooling performance. Thermal simulation results indicate a 5°C to 15°C cooler temperature at the same incoming air flow rate and temperature.

According to an aspect of the disclosure, a system is disclosed for cooling a plurality of in-line memory modules which includes a heatsink and sliding thermal interface material ("TIM") pads. The heatsink includes a base, a plurality of thermally conductive fins, and a plurality of pedestals. The plurality of thermally conductive fins extend in a first direction away from the base. The plurality of pedestals extend in a second direction away from the base and opposite the first direction. The sliding TIM pads may be positioned between each of the plurality of pedestals and an adjacent in-line memory module. The sliding TIM pads provide thermal connections between the plurality of pedestals and an adj acent in-line memory module when the plurality of pedestals contact the sliding TIM pads. The plurality of pedestals further include a first leg and a second leg. The first leg and the second leg may be configured to move between a first position and a second position. In the first position, the first and second legs contact sliding TIM pads. In the second position, the first and second legs are spaced apart from sliding TIM pads and do not contact pads.

According to another aspect of the disclosure, a system for cooling a plurality of in-line memory modules includes a heatsink and sliding thermal interface material ("TIM") pads. The heatsink further includes a base and a plurality of thermally conductive fins. The plurality of thermally conductive fins extends in a first direction away from the base. The plurality of pedestals extends in a second direction away from the base and opposite the first direction. The sliding TIM pads may be positioned between each of the plurality of pedestals and an adjacent in-line memory module. The sliding TIM or TIM pads can provide thermal connections between the plurality of pedestals and an adjacent in-line memory module when the plurality of pedestals contact the sliding TIM pads. The plurality of pedestals have end surfaces comprising a non-planar shape.

According to another aspect of the disclosure, an in-line memory module includes a printed circuit board ("PCB") having a first surface configured to receive a plurality of integrated circuit ("IC") chips. The PCB has a first row, a second row overlying the first row, and a third row overlying the first and second rows. A first plurality of chips are arranged in a first row. A second plurality of chips are arranged in a third row, such that the first and second plurality of chips are spaced apart from one another by the second row.

According to another aspect of the disclosure, an in-line memory module includes a printed circuit board ("PCB") having a first surface configured to receive a plurality of integrated circuit ("IC") chips. The PCB further includes a first row, a second row overlying the first row, a third row overlying the first and second rows, and a fourth row overlying the first, second, and third rows. A first plurality of chips arranged in a first row. A second plurality of chips are arranged in a second row. A third plurality of chips are arranged in a third row. A fourth plurality of chips are arranged in a fourth row. The first plurality of chips and the third plurality of chips are aligned with one another. The second plurality of chips and the fourth plurality of chips are aligned with one another.

According to another aspect of the disclosure, a heatsink for a plurality of in-line memory modules include a base; a plurality of thermally conductive fins, a plurality of thermally conductive pedestals, and sliding thermal interface material ("TIM") pads. The plurality of thermally conductive fins may extend in a first direction away from the base. The plurality of thermally conductive pedestals may extend in a second direction away from the base and opposite the first direction. At least some of the plurality of thermally conductive pedestals comprise a first leg and a second leg. Each of the at least some of the plurality of thermally conductive pedestals may be positioned in a space between adjacent in-line memory modules of the plurality of in-line memory modules and may be configured to move between a first position and a second position. The sliding TIM pads may be positioned between each pedestal of the at least some of the plurality of thermally conductive pedestals and a directly adjacent in-line memory module. When the at least some of the plurality of thermally conductive pedestals are in the first position, each of the first and second legs contact the sliding TIM pads, such that the sliding TIM pads thermally couple each of the at least some of the plurality of thermally conductive pedestals to the directly adjacent in-line memory module. When the at least some of the plurality of thermally conductive pedestals are in the second position, the first and second legs of each of the plurality of the at least some of the thermally conductive pedestals are spaced apart from adjacent sliding TIM pads, so as to create gaps between the sliding TIM pads and the at least some of the plurality of thermally conductive pedestals.

According to another aspect of the disclosure, a system comprises a heat sink as described in paragraph **[0009]** above and, a plurality of in-line memory modules ("IMMs"). Each of the plurality of IMMs further comprises a printed circuit board ("PCB") and a plurality of integrated circuit ("IC") chips.

According to another aspect of the disclosure, a system for cooling a plurality of in-line memory modules includes a heatsink. The heat sink further comprises a base, a plurality of thermally conductive fins, a plurality of thermally conductive pedestals, and sliding thermal interface material ("TIM") pads. The plurality of thermally conductive fins may extend in a first direction away from the base. The plurality of thermally conductive pedestals may extend in a second direction away from the base and opposite the first direction. The sliding thermal interface material ("TIM") pads may be positioned between each of the plurality of thermally conductive pedestals and an adjacent in-line memory module. The sliding TIM pads may thermally couple the plurality of thermally conductive pedestals and an adjacent in-line memory module of the plurality of in-line memory modules. The heatsink may optionally include a vapor chamber.

According to another aspect of the disclosure, a system for cooling a plurality of in-line memory modules includes sliding thermal interface material ("TIM") pads and a heatsink thermally coupled to the in-line memory modules through the sliding TIM pads. The heatsink further includes a base, a plurality of thermally conductive fins, and a plurality of pedestals. The base extends in a plane. The plurality of thermally conductive fins extend in a first direction away from the base. The plurality of pedestals extend in a second direction away from the base and opposite the first direction. The sliding TIM pads are positioned between each of the plurality of pedestals and an adjacent in-line memory module. The plurality of pedestals further include a first leg and a second leg. The first and second legs are configured to move between a first position and a second position.

### BRIEF DESCRIPTION OF THE DRAWINGS

FIG. 1 depicts a schematic view of an example cooling system or system for thermal management of an in-line memory module according to an aspect of the disclosure.
FIG. 2 is an enlarged area of a portion of FIG. 1.
FIG. 3 is another view of the example system of FIG. 1.
FIG. 4 is an enlarged area of a portion of FIG. 3.
FIG. 5 is a schematic example front view of a portion of the heatsink according to an aspect of the disclosure.
FIG. 6 is a schematic top view of a portion of the heatsink prior to assembly according to an aspect of the disclosure.
FIG. 7 is a schematic example clip according to an aspect of the disclosure.
FIG. 8A is an example cooling system according to an aspect of the disclosure.
FIG. 8B is an example cooling system according to an aspect of the disclosure.
FIG. 9 is an example cooling system according to an aspect of the disclosure.
FIG. 10 is an example cooling system according to an aspect of the disclosure.
FIGS. 11-12 depict example in-line memory modules according to an aspect of the disclosure.
FIGS. 13-14 depict perspective views of an example cooling system for in-line memory modules according to an aspect of the disclosure.
FIG. 15 depicts another view of an example cooling system according to an aspect of the disclosure.
FIGS. 16-17 depict an example cooling system according to an aspect of the disclosure.
FIG. 18 depicts an example schematic in-line memory module according to an aspect of the disclosure.
FIG. 19 depicts an example schematic in-line memory module according to an aspect of the disclosure.
FIG. 20 depicts an example schematic in-line memory module according to an aspect of the disclosure.
FIG. 21 depicts an example schematic in-line memory module according to an aspect of the disclosure.
FIG. 22 depicts an example schematic in-line memory module according to an aspect of the disclosure.
FIG. 23 is a schematic cross-sectional view of the in-line memory module depicted in FIG. 22.
FIG. 24 depicts an example schematic heat spreader that can be incorporated into the example printed circuit board of the in-line memory module of FIG. 23.
FIGS. 25A-25B depict an example method of manufacturing a printed circuit board with an integrated heat spreader according to an aspect of the disclosure.
FIGS. 26A-26B depict an example method of manufacturing a printed circuit board with an integrated heat spreader according to an aspect of the disclosure.
FIG. 27A depicts a schematic cross-sectional view of an in-line memory module according to an aspect of the disclosure.
FIG. 27B depicts a schematic cross-sectional view of an in-line memory module according to an aspect of the disclosure.
FIG. 28 depicts an example system for thermal management of an in-line memory module according to an aspect of the disclosure.
FIG. 29 depicts an exploded schematic view of FIG. 28.
FIG. 30 depicts an example heatsink of FIG. 28.
FIG. 31A depicts an example schematic side view of a portion of the system of FIG. 28.
FIG. 31B illustrates an example schematic component for the system of FIG. 28 according to an aspect of the disclosure.
FIG. 31C illustrates an example system incorporating multiple systems for thermal management of in-line memory modules.
FIGS. 32A-32B depict front and rear perspective views of an example heatsink for use in a system for thermal management of an in-line memory module according to an aspect of the disclosure.
FIG. 32C depicts a system for thermal management of an in-line memory module according to an aspect of the disclosure.
FIG. 32D depicts a side view of the system of FIG. 32C.
FIG. 33 depicts an example in-line memory module according to an aspect of the disclosure.
FIG. 34 depicts an example system incorporating the in-line memory module of FIG. 33 and an example heatsink according to an aspect of the disclosure.
FIG. 35 depicts the example heatsink shown in FIG. 34.
FIG. 36 depicts a portion of the example heatsink system shown in FIG. 34.
FIG. 37 depicts the example heatsink shown in FIG. 34 with example panels removed according to an aspect of the disclosure.
FIG. 38 depicts a side view of the system shown in FIG. 34.
FIG. 39 depicts a side view of the heatsink shown in FIG. 35.
FIG. 40 depicts a perspective view of a heatsink according to an aspect of the disclosure.
FIG. 41 depicts an example heatsink according to an aspect of the disclosure.
FIG. 42 depicts a front elevation view of the heatsink of FIG. 41.
FIG. 43 depicts an example system for thermal management of an in-line memory module that incorporates the heatsink of FIG. 41.

### DETAILED DESCRIPTION

Various systems, apparatus, processes and methods are disclosed to provide for thermal management of in-line memory modules. In some examples, a system includes an improved heat sink and a plurality of in-line memory modules. The plurality of in-line memory modules may be arranged side-by-side along a main printed circuit board of the system. Each of the in-line memory modules may further include its own printed circuit board and a plurality of integrated circuit ("IC") chips mounted to the printed circuit board of each in-line memory module. The plurality of in-line memory modules can take on various configurations, including without limitation, a dual in-line memory module with a plurality of DRAM chips mounted to the in-line memory module. In some examples, the heatsink can be configured as a unitary structure that allows for the simultaneous positioning of the heatsink between each of the plurality of in-line memory modules. Such heatsinks can be configured to provide improved thermal contact between the plurality of in-line memory modules and the heatsinks. In still other examples, instead of a system that incorporates a single heatsink structure configured to provide thermal distribution or dissipation of heat generated by multiple in-line memory modules in the system, improved heatsinks are also disclosed that are configured to be coupled to individual in-line memory modules in the system, such that multiple heatsinks may be used to cool corresponding and individual in-line memory modules.

In some examples, the heatsink of the system can include an elongated base that extends across top surfaces of the plurality of in-line memory modules. A plurality of thermally conductive pedestals can extend away from the elongated base. Some of the pedestals may be configured and arranged to be positioned in the space between directly adjacent in-line memory modules. In such examples, the pedestals will be adjacent two in-line memory modules: a first in-line memory module will be adjacent one side of the pedestal and a second in-line memory module will be adjacent the oppose side of the pedestal. The pedestals may be thermally coupled to the in-line memory modules with a thermal interface material ('TIM") pad, such as a sliding TIM pad that allows for easy thermal coupling of the pedestals to the directly adjacent in-line memory modules and that is also durable to also allow for the repeated assembly and removal of the heatsink. The heatsink structure can help to improve dissipation and distribution of heat between each of the directly adjacent in-line memory modules. In some examples, the pedestals may include first and second legs that are movable and allow for improved contact between each pedestal and a directly adjacent TIM pad. In other examples, the pedestals may include a vapor chamber to allow for enhanced dissipation of heat within the system. In some examples, the vapor chamber may be positioned only in the base of the heatsink, or in other examples, the vapor chamber may additionally extend within each of the pedestals. In still other examples, there may be multiple vapor chambers thermally conductive fins may extend upwardly from the base or the thermally conductive fins may instead or additionally be positioned laterally adjacent the pedestals and thermally connected to the pedestals by a pedestal connector.

In still other examples, thermal distribution of heat generated by the in-line memory module may be further enhanced due to the configuration of the in-line memory module itself. In some examples, an in-line memory module may include a pseudo-tall printed circuit board that may have a form factor of 2U or greater. This can allow for an increased area and space between IC chips mounted to the printed circuit board of the in-line memory module, which can lead to increased thermal distribution and dissipation of heat generated by the in-line memory module.

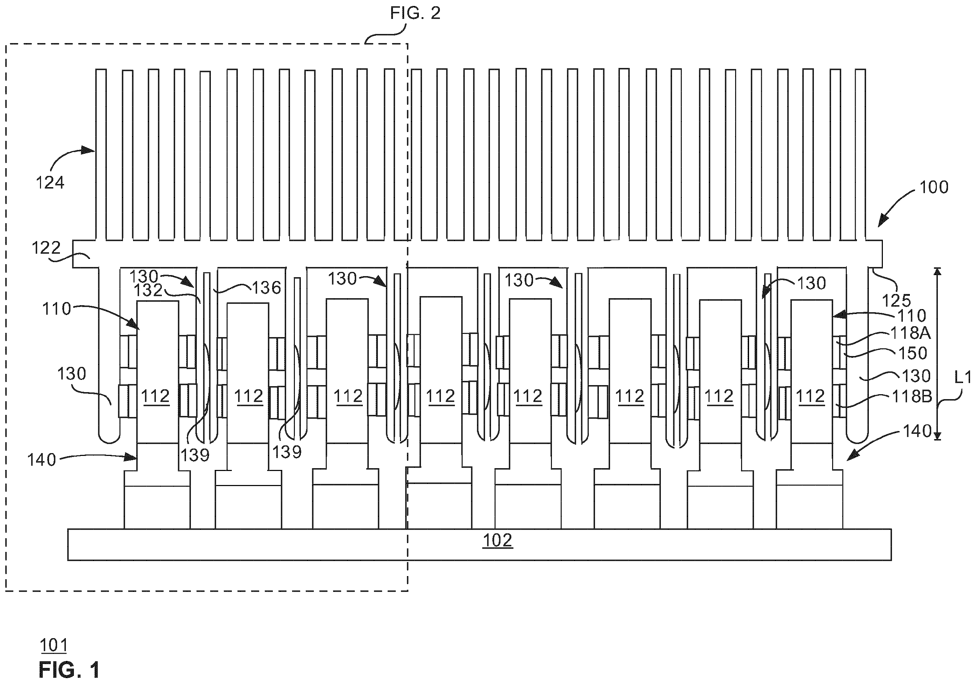

FIG. 1 illustrates an example system 101 that incorporates an example heatsink 100 for heat dissipation of a plurality of in-line memory modules, such as Dual In-line Memory Modules ("DIMMs"), Small Outline DIMMs ("SODIMMs"), Rambus In-line Memory Modules ("RIMMs"), Single In-Line Memory Modules ("SIMMs"), and other types of in-line memory modules. In one example, heatsink 100 may be coupled to a plurality of in-line memory modules, such as one or more DIMMs 110, which are, in turn coupled to a mother or main board 102. Heatsink 100 may be comprised of an intermediate base 122, a plurality of fins 124 extending from intermediate base 122 in a first direction, and a plurality of pedestals 130 extending from intermediate base 122 in a second opposed direction. Heatsink 100 can provide for an active fit or contact between DIMMs 110 and pedestals 130 due to the pedestals 130 being movable and configured to actively contact or move towards each DIMM 110 and/or components joining DIMMs 110 to pedestals 130.

Pedestals 130 of heatsink 100 may be positioned between each DIMM 110 to facilitate heat distribution and dissipation of at least the heat generated by each DIMM 11. For example, pedestals 130 can facilitate heat distribution and dissipation in each space between the DIMMs 110, including distributing heat to fins of heatsink 100. As shown, pedestals 130 may extend longitudinally in a direction away from intermediate base 122 and toward mother or main board 102. In this example, pedestals 130 can extend a length L1 away from bottom surface 125 of intermediate base 122 and towards main board 102. In one example, length L1 may be a length that is sufficient to overlie exposed surfaces of printed circuit board ("PCB") 112 when PCB 112 of DIMM 110 is positioned within DIMM connector 140. Pedestals 130 can extend to any desired length and the length of all pedestals 130 can be the same or one or more pedestals 130 may have a length that varies from the other pedestals 130. Pedestals 130 may be formed from a same or different material as intermediate base 122 and fins 124, as will be discussed in more detail herein.

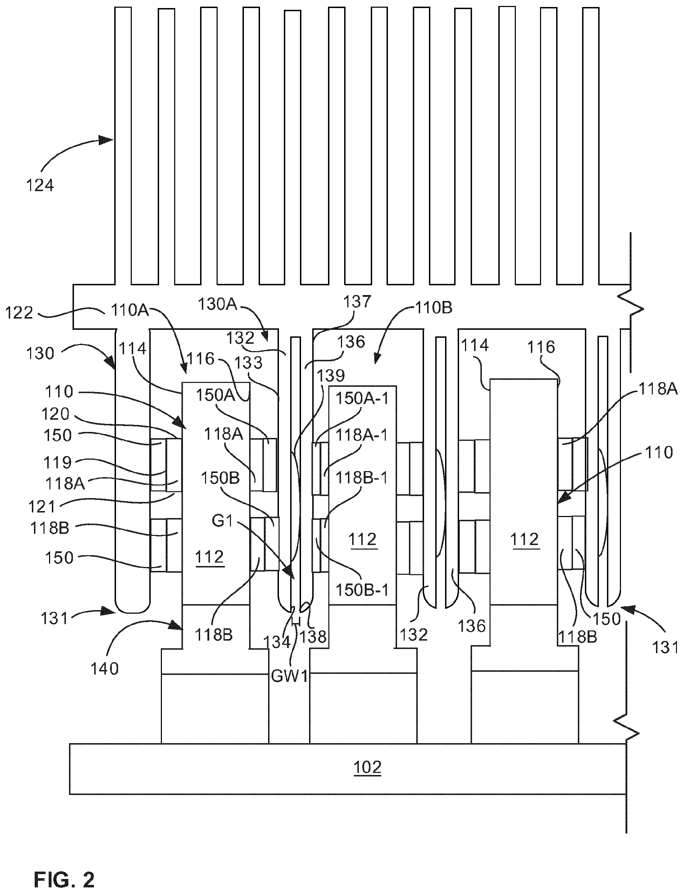

Pedestals may include at least a single leg, such as pedestals 130 shown at outermost ends of heatsink 100. Pedestals 130 may further include at least two legs that are spaced apart from one another. For example, pedestals 130 that are positioned between each DIMM 110 include first leg 132 and second leg 136. As shown in FIG. 2, first leg 132 includes an exterior surface 133 and an interior surface 134. Second leg 136 similarly includes an exterior surface 137 and an interior surface 138. First and second legs 132, 136 are shown spaced apart from one another. In this example, first leg 132 and second leg 136 may be biased apart from one another by a biasing element positioned between first and second legs 132, 136, and in this example, biasing element 139 may be positioned between interior surface 134 of first leg 132 and interior surface 138 of second leg 136. Biasing element 139 may be any element or structure capable of biasing first and second legs 132, 136 away from one another. In one example, biasing element 139 may be a spring, and in one further example, biasing element 139 may be a pre-loaded compression spring that biases first leg 132 and second leg 136 apart or away from one another, and as shown, closer to the respective DIMM 110 that is directly adjacent each of the respective first and second legs 132, 136. In this example, a gap G1 may exist between interior surfaces 134, 138 that has a gap width GW1. Biasing element 139 may be formed from one or more of aluminum, steel, stainless steel, copper, nitinol (nickel titanium), or any other material(s) that can be implemented to manufacture biasing element 139. In this example, pedestals may be further comprised of a resilient material to allow for movement of the first and second legs 132, 136. In other examples, there may be no biasing element provided between first and second legs, and first and second legs 132, 136 may instead be only comprised of a resilient material that is configured so that first and second legs 132, 136 are biased apart or away from one another. IN still other examples, the first and second legs 132, 136 can instead be biased together and a force applied to push the first and second legs apart from one another and to contact the TIM pads. It is to be appreciated that some of the pedestals 130 may include only a single leg, such as the outermost pedestals 130 that are not positioned between two directly adjacent in-line memory modules. The outermost pedestals can otherwise include the same features as the dual leg pedestals 130.

Pedestals 130 may have rounded edges. Pedestals 130 that are positioned at the outermost ends of heatsink 100 and that are not positioned between DIMMs 110 are shown having non-planar edges at outer end 131 of pedestals 130. In this example, outer ends 131 have edge surfaces that are rounded. Pedestals 130 positioned between DIMMs 110 may include a first leg 132 that has a rounded edge where exterior surface 133 transitions to outer end 131 of pedestal 130, whereas the outer edge where interior surface 134 transitions to outer end 131 of pedestal 130 is not rounded. Second leg 136 similarly includes a rounded edge where exterior surface 137 transitions to outer end 131 of pedestal 130 and interior surface 138 does not. In other examples, first and second legs 132, 136 may be fully rounded, so as to have individual profiles that are more similar to pedestals 130 that are positioned at outermost ends of heatsink 100. The rounded ends of pedestals 130 can allow pedestals 130 to slide into and out of spaces between DIMMs 110 without damaging sliding TIM 150. In still other examples, pedestals 130 may not have rounded edges and outer end 131 may form corners where exterior surfaces 133, 137 and interior surfaces 134, 138 transition to outer end 131. In other examples, any type of end surface can be implemented, including partially rounded, non-planar, and the like.

Each DIMM 110 may include a PCB 112 and a plurality of electronic devices disposed at both first surface 114 and second surface 116 of PCB 112, as more easily seen in the enlarged view of FIG. 2. Electronic devices can include a plurality of integrated circuit ("IC") chips, such as memory chips, such as DRAM chips mounted or bonded to one or both surfaces 114, 116 of PCB 112 of DIMM 110. Reference made to "chips" throughout the specification will refer to IC chips, including but not limited to DRAM chips. In this example, upper chips 118A and lower chips 118B, which include upper chips 118A-1 and lower chips 118B-1 (collectively "chips 118A, 118B" or "chips 118") may be collectively arranged in an array of eight chips, but any arrangement and number of chips may be utilized on PCB 112 of DIMM 110. Other active and/or passive devices can also be provided at one or both of first and second surfaces 114, 116. DIMM 110 may be coupled to main board 102 using DIMM connectors 140 that are arranged across main board 102. DIMM connectors 140 can be any type of connector configured to receive and secure DIMM 110 to main board 102, including known DIMM connectors. In this example, pins of PCB 112 may connect with main board 102 and DIMM connectors 140 can secure each PCB 112 to main board 102.

Gap pad or sliding thermal interconnect material ("TIM") pad or sliding TIM 150 may be used to thermally couple DIMM 110 with directly adjacent pedestals 130. In this example, sliding TIM 150 may be selected for its durability or ability to be used multiple times. For example, sliding TIM 150 can accommodate heatsink 100 being inserted and removed multiple times can improve serviceability of the system when it is necessary to change a component coupled to DIMM 110 or an entire DIMM that may be underperforming due to any one of a number of issues. Examples of suitable sliding TIM 150 include but are not limited to Henkel micro TIM and Laird OptiTIM. In other examples, no TIM pad is required and other thermally conductive materials, such as grease and the like can be implemented.

As shown, sliding TIM 150 may overlie an outer surface of chip 118, and in this example, sliding TIM 150 may overlie surface 119 of chip 118. Sliding TIM 150 may be sized so as to cover an entire surface of chip 118 so that TIM 150 extends from a first edge surface 120 of chip 118 to a second edge surface 121 of chip 118, but in other examples, sliding TIM 150 may cover less than an entire surface of chip 118 or extend beyond edge surfaces 120, 121 of chip 118. In still other examples, sliding TIM 150 may be deposited as a continuous sheet of TIM that extends continuously between at least two chips, such as upper chip 118A and lower chip 118B, so as to overlie a greater surface area of pedestal 130. In addition to sliding TIM, epoxy, another adhesive, or other materials can be deposited between PCB 112 and DIMM 110 and pedestal 130 to further secure heatsink 100 to DIMM 110. Additionally or alternatively, screws can be used to attach heatsink 100 to board 102.

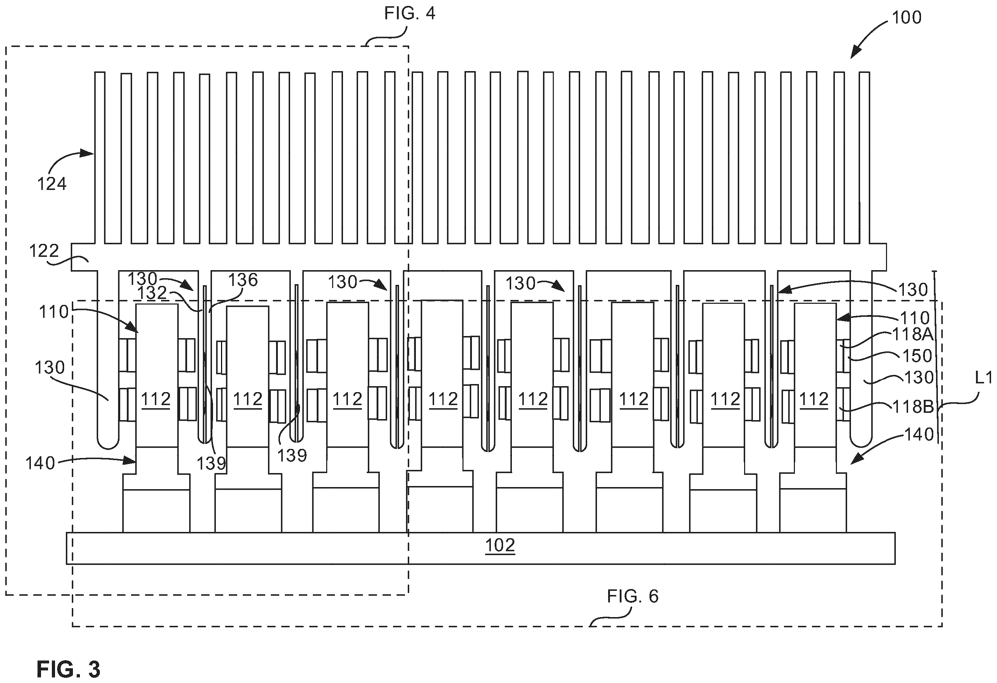

First leg 132 and second leg 136 of each of pedestals 130 in heatsink 100 may be movable so as to provide for thermal coupling between each pedestal 130 and an adjacent DIMM 110 and TIM 150. In this example, first and second legs 132, 135 can further allow for an active fit or active contact between sliding TIM 150 and directly adjacent pedestals 130. For example, as shown in FIG. 2 and to facilitate discussion, TIM 150 can include TIM 150A, 150B, 150A-1, 150B-1; DIMM 110, includes DIMM 110A, 110B; IC chips 118 can further include chips 118A-1, 118B-1; and pedestals 130 can include pedestal 130A. It is to be appreciated that each DIMM 110 and TIM in system 100 can include similar features. Pedestals 130 can each include first leg 132 and second leg 136. In this example, first and second legs 132, 136 of pedestals 130 are configured to move from a first position, as shown, to a second position. In the first position, first and second legs 132, 136 of pedestals 130 may be thermally coupled to and directly contact adjacent TIM 150A, 150A-1, 150B, 150B-1. In the second position, first and second legs 132, 136 are spaced apart from the directly adjacent TIM 150A, 150A-1, 150B, 150B-1 and the directly adjacent DIMM 110, which will be further illustrated and discussed in FIG. 3-4 herein. In other examples, the first position can be defined as the position of first and second legs 132, 136 during assembly of heatsink 100 to each DIMM 110 and the second position can be defined as the position where first and second legs 132, 136 of pedestals 130 contact directly adjacent TIM 150 and are also thermally coupled to directly adjacent DIMM 110.

As shown in one example, with reference to pedestal 130A, in the first position, first leg 132 may be positioned directly adjacent and contact TIM 150A, 150B, which is coupled to DIMM 110 positioned to the left of leg 132. As shown, exterior surface 133 of first leg 132 contacts TIM 150A, 150B, which in turn thermally couples DIMM 110 and chips 118A, 118B to pedestal 130A. Similarly, second leg 136 may be directly adjacent and contact TIM 150A-1, 150B-1, which are coupled to DIMM 110B positioned to the right of second leg 136. As shown, outer exterior surface 137 of second leg 136 contacts TIM 150A-1, 150B-1, which in turn thermally couples DIMM 110B and chips 118A-1, 118B-1 to pedestal 130A.

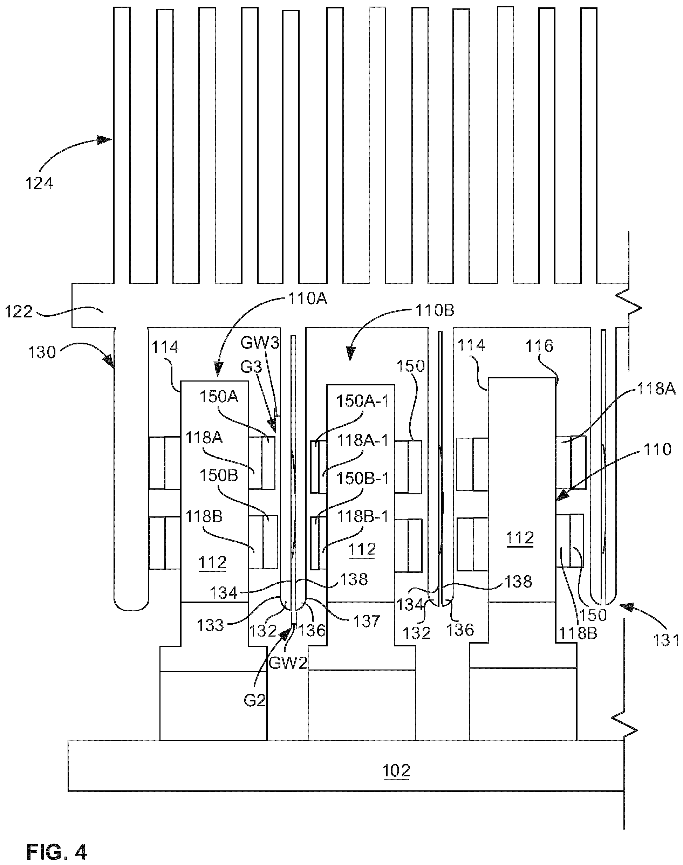

FIG. 3 illustrates example heatsink 100 prior to being thermally coupled to sliding TIM 150 adjacent each DIMM 110. In this example, biasing element 139 is compressed in each pedestal 130 positioned between adjacent DIMMs 110 so that first and second legs 132, 136 are spaced close to one another. As better shown in the enlarged view of FIG. 4, interior surface 134 of each first leg 132 of pedestal 130 and interior surface 138 of each second leg 136 of pedestal 130 are spaced close together, such that there is a pre-assembly gap G2 between interior surfaces 134, 138 that has a gap width GW2. There is also a gap G3 between each first leg 132 and the directly adjacent sliding TIM 150 and each second leg 136 and the directly adjacent sliding TIM 150. By compressing first and second legs 132, 136 together, pedestals 130 of heatsink 100 can be positioned between each DIMM 110, such that there is no contact between sliding TIM 150 and at least one of the first and second legs 132, 136. In this example, pedestals 130 are positioned so that both first and second legs 132, 136 do not contact or engage sliding TIM 150.

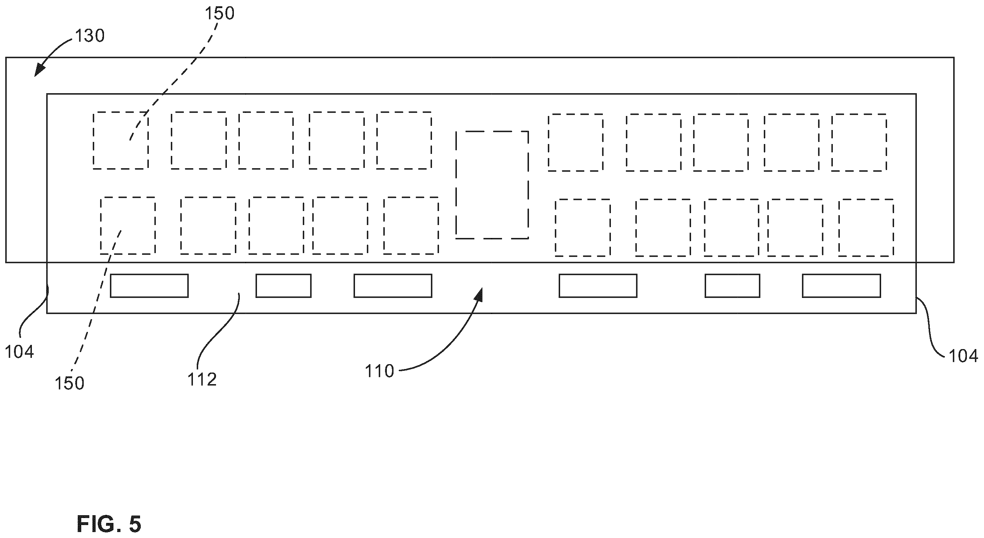

During assembly and prior to coupling of heatsink 100 to DIMM 110 with sliding TIM 150, first and second legs 132, 136 of pedestals 130 may be brought closer together, which results in compression of biasing element 139. For example, with reference to FIG. 5, a front view of DIMM 110 and a pedestal 130 overlying DIMM 110 are shown removed from the overall assembly for ease of discussion. Pedestal 130 is shown overlying, but not yet bonded to sliding TIM 150, which further overlies chips 118A, 118B disposed at PCB 112. As shown, pedestal 130 extends laterally beyond outer side edges 104 of PCB 112 of DIMM 110.

In this example, eight in-line memory modules are shown, and in this example, eight DIMMs 110 are shown. In other examples, any number of DIMMs 110 can be implemented within system 101. For example, there may be as few as two DIMMs or more than two DIMMs 110. Similarly, should a fewer number of DIMMs 110 be implemented, heatsink 110 may be modified so that pedestals are positioned between each DIMM 110 in the system. In such examples, heatsink may include two outermost pedestals, and a pedestal between two directly adjacent DIMMs.

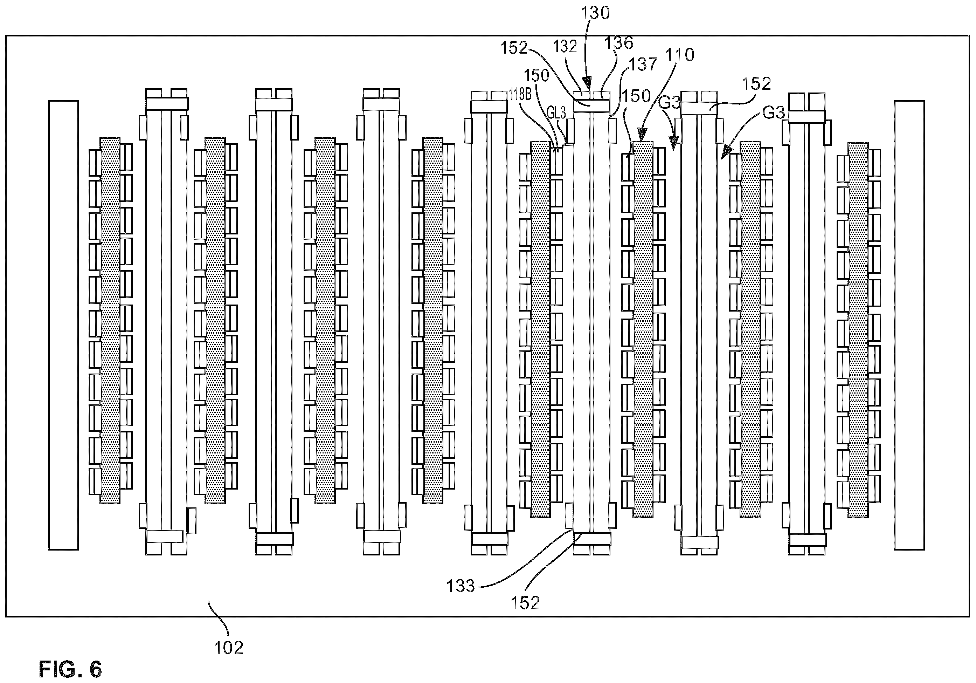

FIG. 6 illustrates a schematic top view showing DIMM 110 and pedestals 130 disposed between each DIMM 110, but the overlying fins 124 (FIG. 4) have been removed for ease of illustration. Pedestals 130 are shown spaced away from sliding TIM 150 and DIMM 110 prior to being coupled with sliding TIM 150 and DIMM 110. Gap G3 is shown between sliding TIM 150 and directly adjacent and respective first and second legs 132, 136.

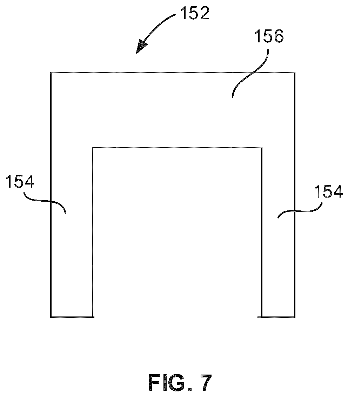

To compress first and second legs 132, 136 together, various mechanisms can be implemented. In one example, a clip or clamp 152 can be placed at outermost ends of first and second legs 132, 136. For example, as shown in FIG. 7, clamp 152 may be a simple u-shaped structure with opposed legs 154 and a base 156 connecting opposed legs 154. In other examples, sliding TIM 150 can be first coupled or applied to pedestals 130, such that pedestals 130 and sliding TIM 150 will be spaced apart from chips, such as chips 118A, 118B illustrated in FIG. 4. In other examples, series of clamps connected together or other mechanism can be used to apply a simultaneous force to compress the first and second legs together, as well as to release the compression force to allow the first and second legs to expand and contact the TIM 150. In still other examples, a user may instead individually apply a compression force and also release the compression force.

When heatsink 100 is to be bonded to DIMM 110, clips 152 may be removed. Removal of clips 152 causes pedestals 130 to expand. For example, with reference back to FIGS. 1-2, biasing element 139 may expand, causing first and second legs 132, 136 of each pedestal 130 to spread further apart until contact is made with sliding TIM 150. Biasing element 139 will continue to cause first and second legs 132, 136 to abut sliding TIM 150 and chips 118A, 118B in order to maintain good contact between pedestals 130 and sliding TIM 150. Once contact is made, sliding TIM 150 may be reflowed to bond DIMM 110 and heatsink 100 together.

In this example, sliding TIM 150 is shown positioned at chips 118A, 118B prior to assembly of heatsink 100. In other examples, sliding TIM 150 may instead be positioned on pedestals 130, and in this example on exterior surface 133 of first leg 132 and exterior surface 137 of second leg 136. In such case, while first and second legs 132, 136 are compressed together during assembly, there may be a gap between sliding TIM 150 and chips 118A, 118B.

During operation, if it becomes necessary to repair and remove one or more DIMMs 110, heatsink 100 may be removed to allow access to the one or more DIMMs 110 which require repair. Due to the use of sliding TIM 150, which allows for reuse of the same TIM 150, once the repairs are made, heatsink 100 can again be assembled and coupled to DIMMs 110. Clips 152 can be provided at ends of first and second legs 132, 136 to compress biasing element 139 and first and second legs 132, 136 together, as shown in FIGS. 5-7. Once DIMM 110 is placed back into DIMM connector 140, clips 152 can be removed to allow for re-expansion of biasing element 139.

A plurality of fins 124 may extend upward from base 122 in a direction away from base 102. Fins 124 may be elongated sheets or panels that can extend lengthwise in a same direction as DIMM 110. In other examples, fins 124 may instead extend in a direction perpendicular to a direction of DIMM 110. Fins 124 may be formed from the same material as pedestals 130 and base 122. But, in other examples, the material comprising fins 124 may differ from either or both of pedestals 130 and base 122.

Heatsink 100 may be a monolithic structure, in which fins 124, intermediate base 122 and pedestals 130 are formed of a unitary block of material. In some examples, fins 124, intermediate base 122, and pedestals 130 may be formed from a single material having a high thermal conductivity. Examples of such material can include, without limitation copper or aluminum, but other materials can be used. Forming heatsink 100 as a monolithic structure can further improve heat dissipation, since heatsink 100 will be formed from a single material where heat generated by DIMM 110 will be thermally conducted by pedestals 130 to intermediate base 122 and fins 124. Further, additional TIM 150 or other materials are not required to attach either fins 124 and/or pedestals 130 to intermediate base 122, which could potentially reduce overall thermal conductivity of heatsink 100.

In other examples, fins 124 and/or pedestals 130 may instead be coupled to intermediate base 122. For example, fins 124 and/or pedestals 130 can be attached to intermediate base 122 through an adhesive or TIM that can both secure fins 124 and/or pedestals 130 to intermediate base 122 and dissipate heat. Similarly, fins 124 and/or pedestals 130 can be bonded to intermediate base 122 through diffusion bonding. For example, an intermediate TIM can be used to attach fins 124 and/or pedestals 130 to DIMM 110 or other material or mechanism.

In an example where heatsink 100 is formed from different materials, any one of fins 124, intermediate base 122, and pedestals 130 may be formed of a different material than the other materials. For example, fins 124 can be manufactured from aluminum and bonded to an intermediate base 122 formed of copper. Pedestals 130 may also be formed from copper and coupled to an intermediate base 122 formed of copper, such as by an additional TIM material. In some examples, heatsink 100 may be formed from a material having a high thermal conductivity, such as copper or aluminum, but other materials or combination of materials may be implemented. In some examples, thermal conductivity may range from 200 W/(m·K) to 2000 W/(m·K), but in other examples thermal conductivity may be less than 200 W/(m·K) or greater than 2000 W/(m·K).

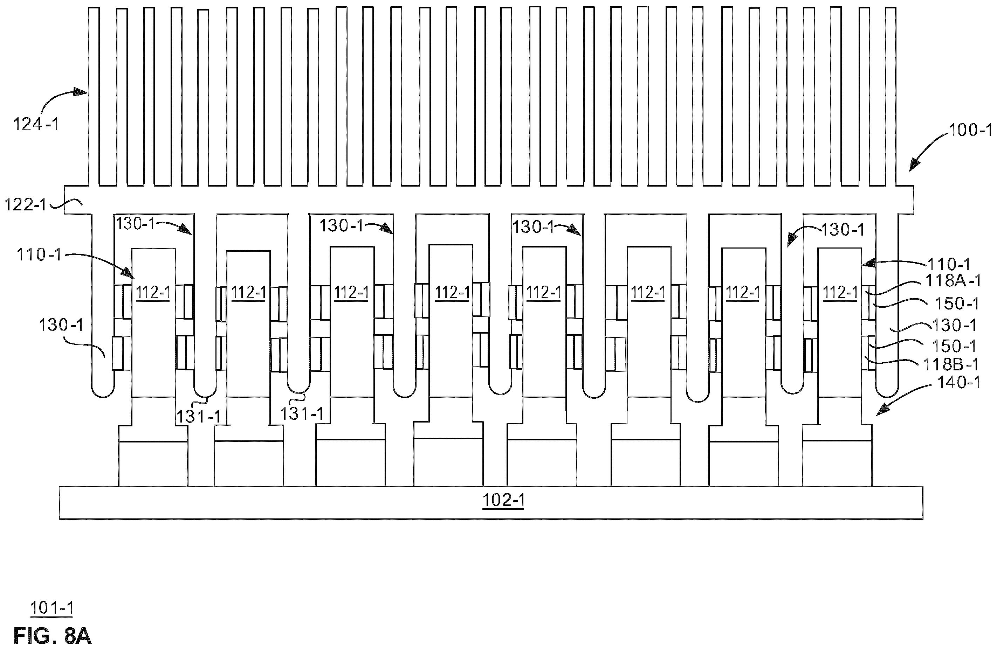

FIG. 8A illustrates another example system 101-1 that implements a heatsink 100-1 for cooling of DIMMs 110-1 having a PCB 112-1 and chips 118A-1, 118B-1 disposed at both sides of PCB 112-1. Features of system 101-1 and heatsink 100-1 are almost identical to system 101 and heatsink 100 and include the same features, which will not be described again in detail for ease of discussion. FIG. 8A differs to the extent that the majority of pedestals and in this example, all pedestals 130-1 are comprised of a single leg that extends from intermediate base 122-1 towards PCB 102-1 and ends or outermost edges or ends 131-1 of pedestals 130-1 are rounded. This configuration of rounded edges 131-1, in combination with sliding TIM 150-1 can aid in the serviceability of DIMMs 110-1. For example, in systems that may rely on an interference fit, where pedestals 130-1 may have a width that is the same size as or slightly larger than a space between DIMMs, rounded edges allow for easy insertion and removal of heatsink 100-1 along sliding TIM 150-1. In other examples, ends 131-1 may be planar and more rectangular in shape.

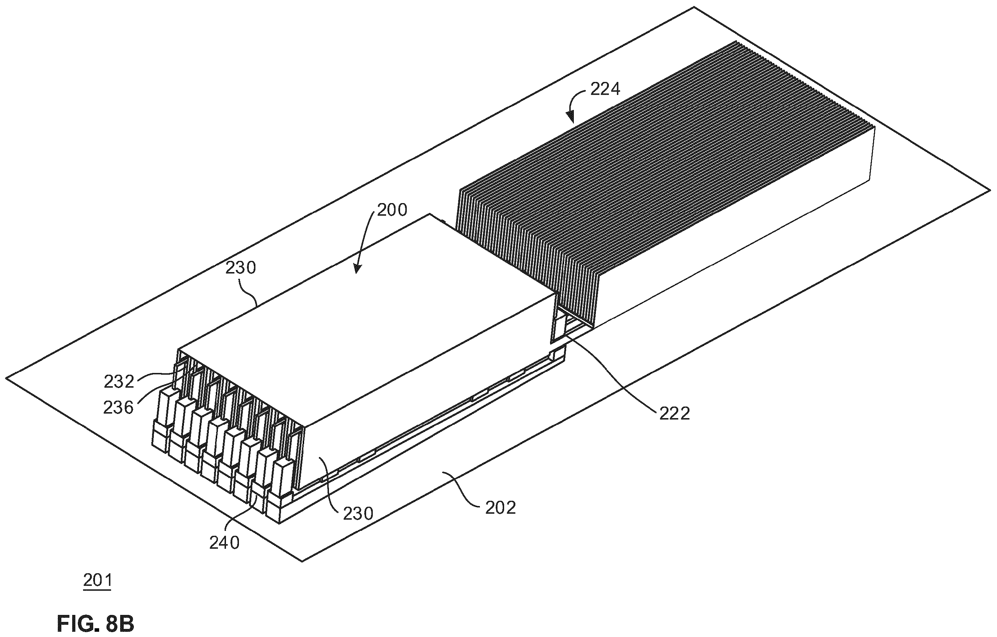

FIGS. 1-8A illustrate example heatsinks 100, 100-1 in which fins 124, 124-1 overlie intermediate base 122, 122-1 and pedestals 130, 130-1. In other examples, fins 124, 124-1 may be positioned at other locations adjacent or near DIMMs 110, 110-1, such as to the right, to the left, to the rear, or to the front of DIMMs 110, 110-1. FIG. 8B depicts an example system 201, which includes structure similar to FIGS. 1-7, except that fins 224 do not extend directly above pedestals 130. Fins 224 are instead positioned at a rear of the device and a thermal connector 222 extends laterally between each pedestal 230 and a fin 224. As shown, a plurality of DIMM connectors 240 house DIMMs. A heatsink 200 includes a pedestal 230, conductive fins 224, and a thermal connector 222 thermally and mechanically connecting pedestal 230 with a corresponding fin 224. Pedestals 230 may be positioned between DIMMs and include a first leg 232 and second leg 236. In this example, DIMMs 210 are covered by a heat spreader surface, but in other examples, the DIMMs may be open to further facilitate heat dissipation.

Thermal connector 222 may extend continuously between pedestals 230 and fins 224. For example, thermal connector 222 may be an elongated portion of conductive metal material or alloy that extends between pedestals 230 and fins 224. Thermal connector 222 can be formed as part of heatsink 200 or it can be a material that is subsequently attached or bonded to pedestals 230 and fins 224 to provide a thermal connection between pedestals 230 and fins 224.

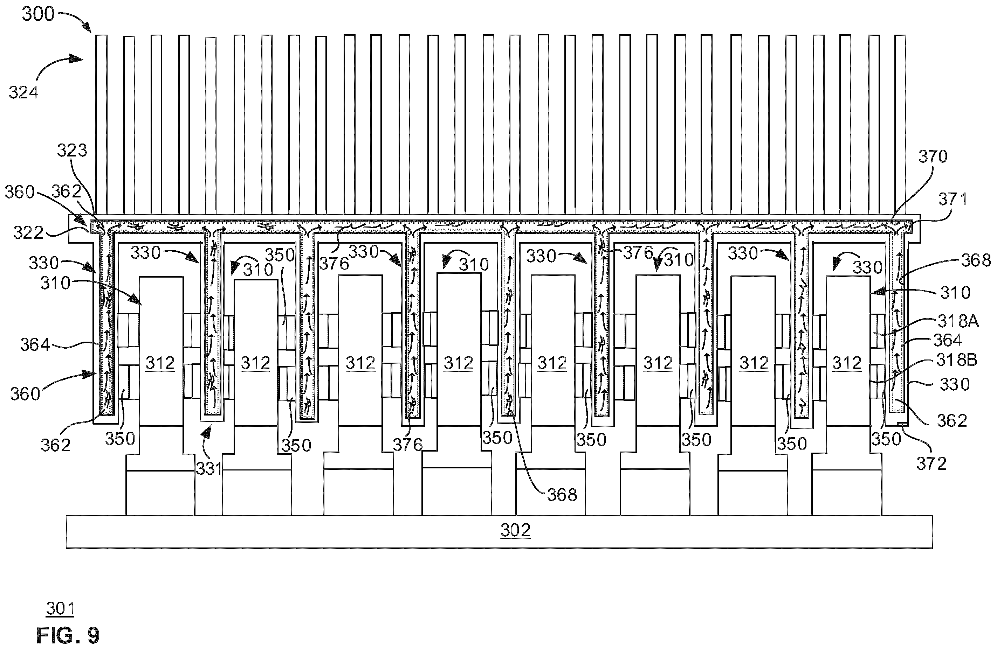

FIG. 9 illustrates another example system 301 that incorporates another example heatsink 300 for heat dissipation of a plurality of in-line memory modules, such as a DIMM, SODIMM, RIMM, and the like. As shown, heatsink 300 may be coupled to a plurality of in-line memory modules, such as one or more DIMMs 310, which are, in turn coupled to a mother or main board 302. As in the previous examples, heatsink 300 may be comprised of an intermediate base 322, a plurality of fins 324 extending from intermediate base 322 in a first direction, and a plurality of pedestals 330 extending away from intermediate base 322 in a second opposed direction. Heatsink 300 differs from prior examples through the incorporation of a vapor chamber 360 to enhance heat dissipation of DIMMs 310.

Pedestals 330 may be disposed in between DIMMs 310 to increase heat dissipation in the space between DIMMs 310. In this example, pedestals 330 are shown positioned between DIMMs 310 and may be a single projection or leg that extends from intermediate base 322 toward main board 302. Pedestals 330 are also shown as including substantially straight edges at ends 331 of each pedestal, as opposed to rounded edges. In other examples, any type of edge can be implemented, including non-planar edges, rounded edges, and the like.

A vapor chamber 360 may be used in connection with heatsink 300 to further enhance cooling and increase heat dissipation of DIMMs 310. In one example, vapor chamber 360 may be incorporated directly into heatsink 300. As shown, an interior chamber 362 is formed within intermediate base 322 and pedestals 330. Wicking material 364 may be provided along any portions of vapor chamber. In this example, wicking material 364 is shown along interior top surface 370 and bottom interior surface 371 of interior chamber 362, as well as along one or more interior chamber wall surfaces 368 of each pedestal 330. Fins 324 may be attached or bonded to top surface 323 of intermediate base 322, which is also the top surface of vapor chamber 360, and extend vertically in an upward direction away from top surface 323 of vapor chamber 360. In some examples, vapor chamber 360 can be further attached or bonded to board 302 using mechanical fasteners, such as screws, rivets, or the like that may join outermost pedestals 330 to a structural base attached to board 302.

In some examples, vapor chamber 360 can be placed into a vacuum and hermetically sealed prior to heatsink 300 being assembled with DIMMs 310. As shown, a working fluid, such as fluid 376 may be introduced into interior chamber 362 through a port that provides access to interior chamber 362, such as port 372 disposed at a surface of vapor chamber 360. A vacuum pump can be connected to vapor chamber 360 through port 372 to create a vacuum within interior chamber 362 and to assist with hermetic sealing of vapor chamber 360.

Each pedestal 330 of heatsink 300 can be bonded to a corresponding and directly adjacent DIMM 310 using sliding TIM 350, as previously described herein. Sliding TIM 350 can be provided directly on pedestals 330 or chips 318A, 318B. In use, each of chips 318A, 318B of each DIMM 310 generate heat, which is transferred through sliding TIM 350 to pedestals 330. Heat within pedestals 330 will be further distributed to intermediate base 322 and distributed across vapor chamber 360 in a horizontal direction that is parallel to a major surface of board 302. Heat may then be further transferred into fluid 376 within interior chamber 362, which may boil or vaporize. The boiling or vaporized fluid 376 circulates and, in this example, vaporized fluid and heat are transferred through thermal fins 324 attached to vapor chamber 360. Wicking material 364 within vapor chamber 360 may further assist with the overall process of heat transfer. As heat is transferred, vaporized fluid 376 will condense back into liquid form and fall back to vapor chamber 360 to allow for a continuous cycle of heating, vaporizing, and condensing.

Fins 324 can be attached to intermediate base 322 prior to bonding DIMMs 310 to pedestals 330 or can be provided after DIMMs 310 and pedestals 330 are bonded. In this example, fins 324 are shown as being a separate component of heatsink 300 that is separately coupled to intermediate base 322, but in other examples fins 324 can be formed as part of a unitary or monolithic structure with intermediate base 322 and pedestals 330. In some examples, fins 324 can be soldered to intermediate base 322 using any thermally conductive material including, without limitation, solder or solder TIM or another thermally conductive material with a high thermal conductivity.

As components of DIMMs 310 need to be repaired or replaced, use of sliding TIM 350 allows for heatsink 300 and pedestals 330 to be easily and temporarily disconnected or moved away from DIMMs 310. Once the desired repairs are completed, heatsink 300 can again be coupled to and bonded with DIMMs 310 using the same sliding TIMs 350 already previously used. TIMs 350 can be reflowed to ensure connection.

In other examples, a vapor chamber may be used in connection with heatsink 300, but may not be directly incorporated into interior portions of heatsink 300. For example, a vapor chamber may instead be positioned exterior to heatsink 300. In one example, the vapor chamber may be a separate structure that is positioned in close proximity to and coupled to DIMMs 310. For example, a vapor chamber may be positioned adjacent to pedestals 330, so that the vapor chamber can efficiently dissipate and/or distribute heat generated by DIMMs 310.

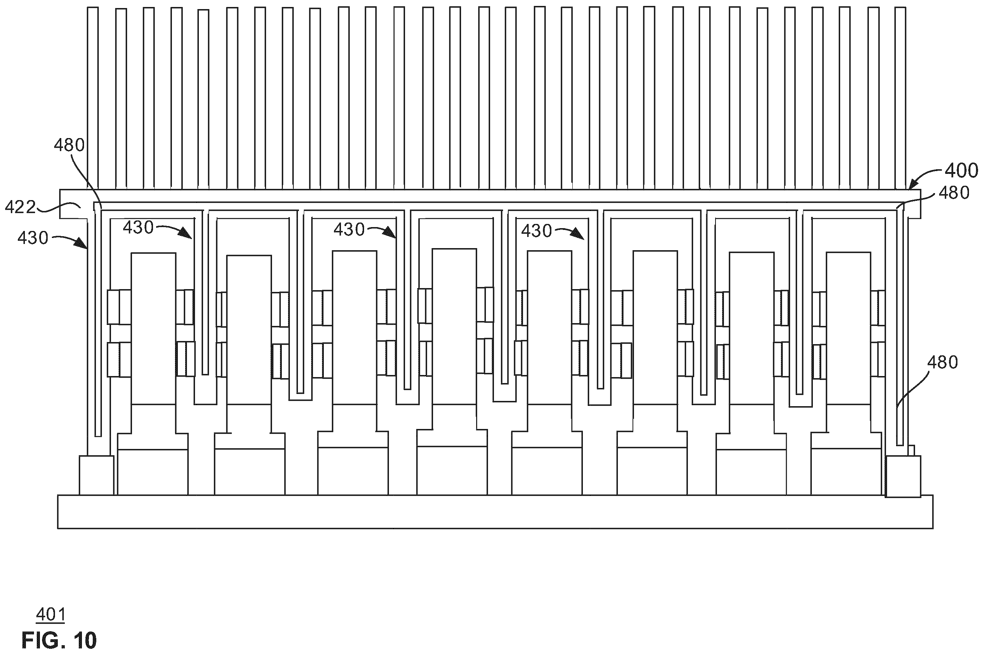

FIG. 10 illustrates an example system 401 configured to provide enhanced cooling of in-line memory modules. Instead of a vapor chamber (or in addition to a vapor chamber), an example heatsink 400 incorporates a heat pipe 480. As shown, heat pipe 480 may be a separate pipe that is incorporated within heatsink 400. Heat pipe 480 may be a series of pipes that run throughout heatsink 400. Heat pipe 480 extends continuously throughout pedestals 430 and intermediate base 422, such that pedestals 430 and intermediate base 422 are in fluid communication with one another. Heat pipe 480 may also include a wicking structure that lines pipe walls and otherwise operates similar to vapor chamber, except for the inclusion of heat pipes.

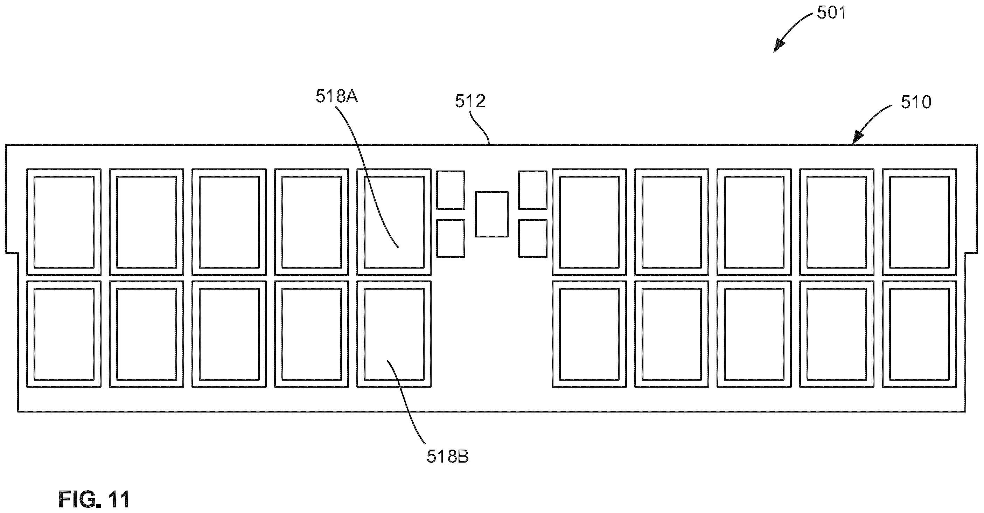

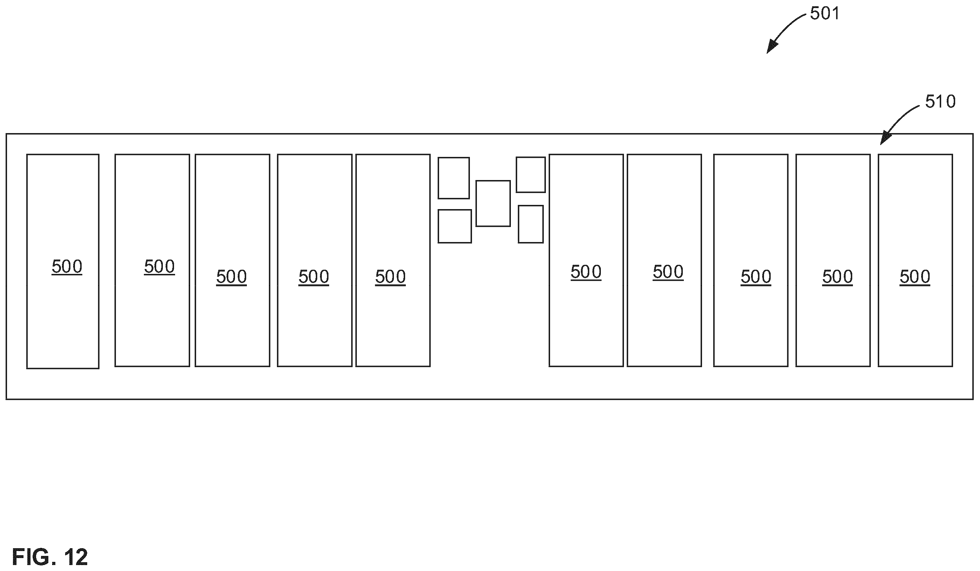

FIGS. 11-14 present an example system 501 for cooling in-line memory modules. FIG. 11 illustrates DIMM 510 having a printed circuit board ("PCB") 512 with a plurality of upper chips 518A in a first row and a plurality of lower chips 518B in a second row that are bonded to PCB 512. As shown in FIG. 12, heatsinks 500 may be provided over chips 518A and 518B in a row of columns. In this example, heatsinks 500 may be planar and formed from various thermally conductive materials, such as, without limitation, copper. TIM 550 overlying each chip may be used to bond heatsinks 500 to chips 518A, 518B.

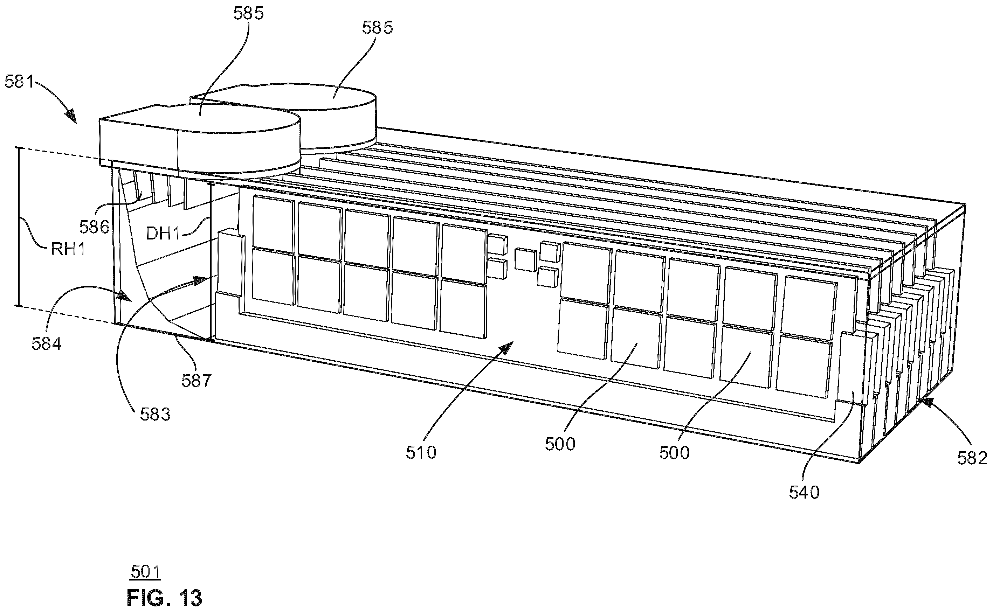

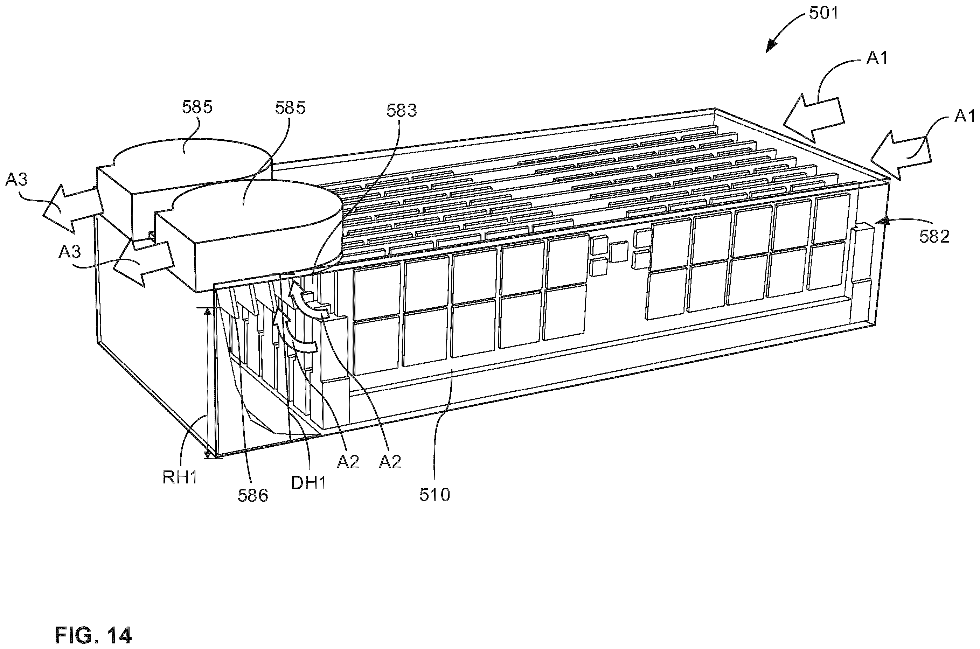

As shown in FIG. 13, a plurality of DIMMs 510 with heatsinks 500 overlying chips 518A, 518B, may be coupled to DIMM connectors 540 that in this example, are mechanical connectors configured to hold DIMMs 510 in an upright position. An air distribution system 581 may be attached to a rear end 583 of the plurality of DIMM connectors 540. In this example, air distribution system 581 may include an air collection surface or ramp 584, at least two fans 585, and baffles 586 coupled to fans 585. Ramp 584 can be a curved surface with an angle of include greater than 0 degrees. Ramp 584 in this example has a ramp height RH1 that is the same height DH1 as DIMMs 510 when positioned within DIMM connectors 540, but in other examples, ramp height RH1 may be greater than or less than DIMM height DH1. Fans 585 are shown positioned parallel to a bottom surface 587 of ramp 584 and overlying ramp 584, with one end of fans 585 coupled to DIMMs 510 and the other end coupled to ramp 584. In use, as shown in FIG. 14, air may enter a front end 582 at one end of DIMMs 510 in the direction of arrows A1. Air can pass through DIMMs 510 and flow out through to an opposed rear end 583 of DIMMS 510 in the direction of arrows A2. Air will be directed upwards to baffles 586 and fans 585 will blow any air distributed by baffles 586 out into the atmosphere in the direction of arrows A3.

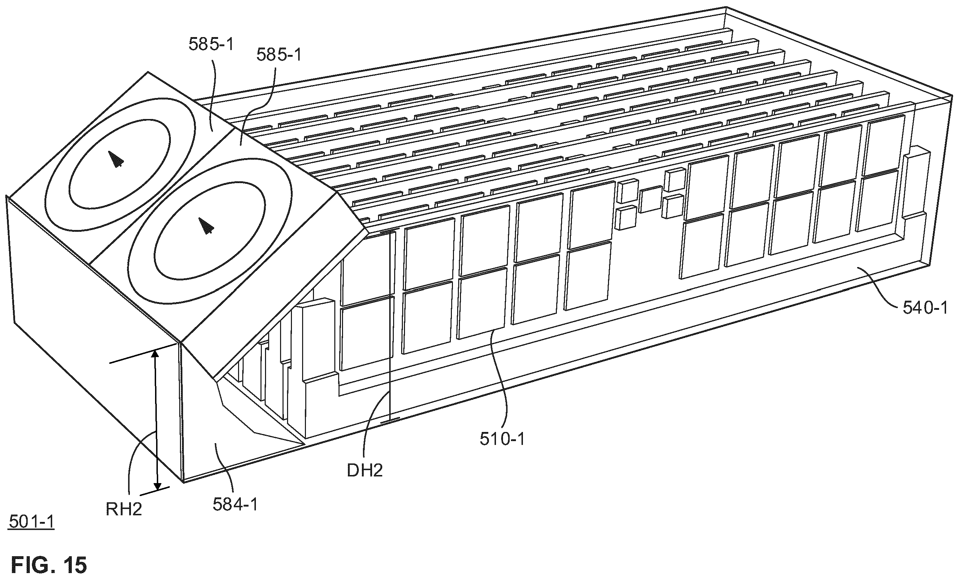

FIG. 15 presents another example system 501-1, in which ramp 584-1 has a ramp height RH2 that is shorter than height DH2 of DIMMs 510-1 within DIMM connector 540-1. Fans 585-1 may overlie ramp 584-1, such that they are positioned at an angle to DIMMs 510.

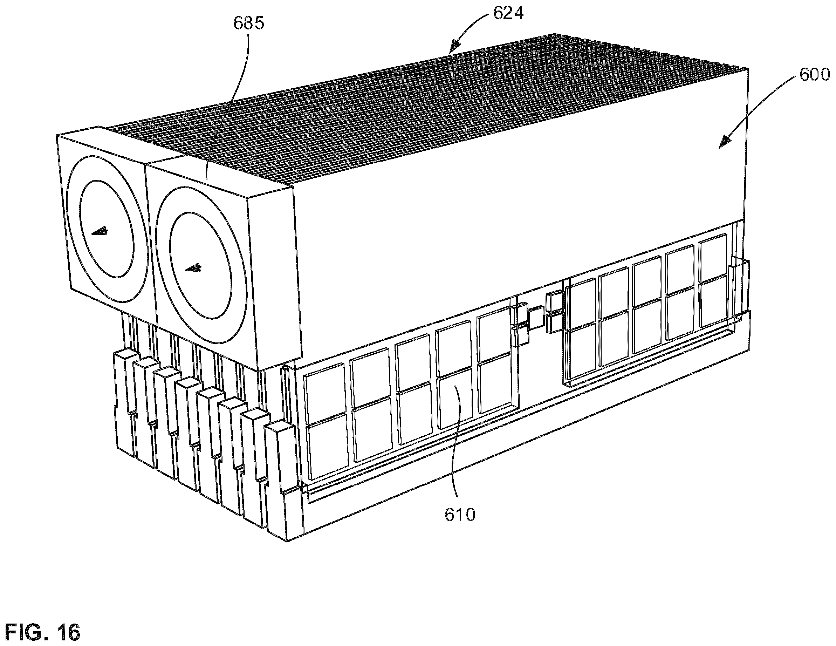

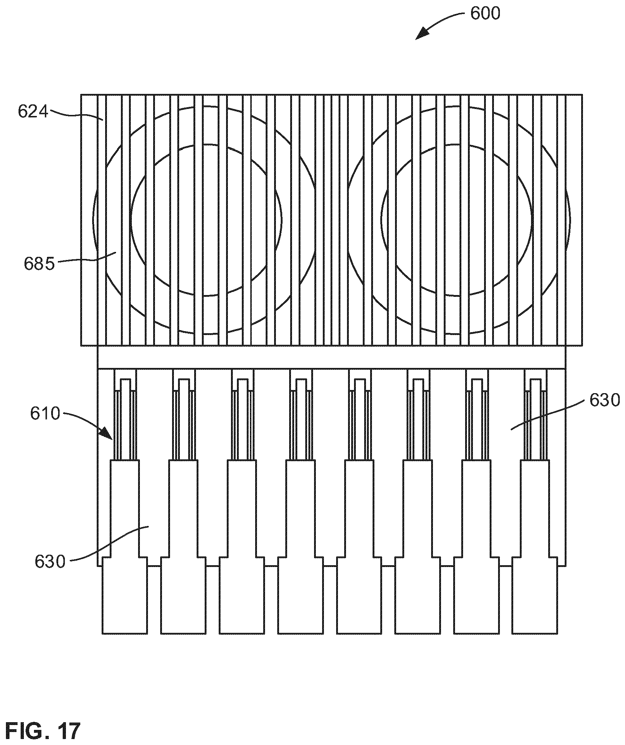

FIGS. 16-17 illustrate the addition of fans to heat spreader 600 that can be similar to heat spreaders disclosed herein. The difference is the addition of fans 685 at one end of fins 624 to help further distribute heated air from fins 624 that is distributed from pedestals 630 positioned between each of the DIMMs 610 that are thermally attached to DIMMs 610. In this example, there are eight DIMMs 610 shown and nine pedestals 630, with seven of the pedestals 630 being positioned between two adjacent DIMMs 610.

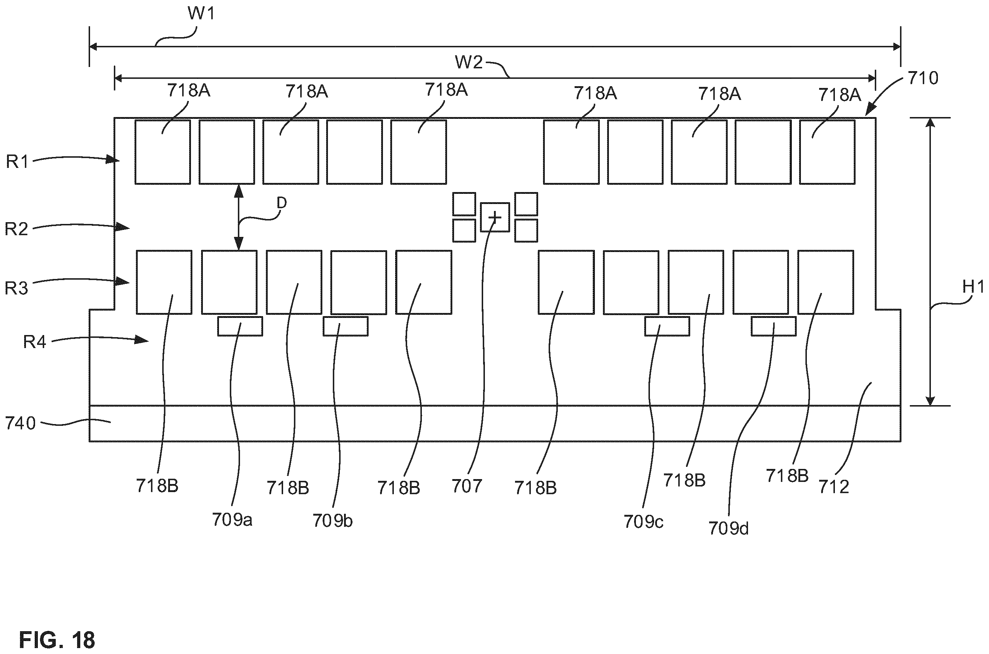

According to another aspect of the disclosure, improved cooling of an in-line memory module can be achieved by increasing the module factor and providing a pseudo-tall module arrangement. FIG. 18 illustrates a first example of a pseudo-tall DIMM with an arrangement that allows for improved cooling and heat dissipation of DIMM structures by providing pseudo-tall DIMM arrangements and increasing the form factor size of DIMM structures. In one example, DIMM 710 may be an MRDIMM that is shown coupled to a separate structure, such as DIMM connector 740, which can, in turn, be coupled to a main or mother board. As shown, DIMM 710 may include a PCB 712 with rows of chips disposed at a first surface. Although only one side of DIMM 710 is illustrated, it is to be appreciated that the opposed second surface of DIMM 710 may be identical and include a similar configuration of chips arranged across the second surface. In still other examples, the rear surface may differ and include no chips at all or a different configuration or arrangement of chips.

Instead of a compact arrangement of only two rows in a 1U form factor, which is commonly used for in-line memory modules, a third row R3 is added to DIMM 710. Further, in this example, chips 718A, 718B are arranged only in the first row R1 and third row R3. As shown, there are ten chips 718A in row R1 and ten chips 718B in row R3, but any number of chips can be implemented. Second row R2 may be skipped or devoid of any chips, such that chips 718A in first row R1 and chips 718B in third row R3 are spaced apart from one another by a distance D. Increasing the distance D between chips 718A, 718B can provide for a 2U form factor, but in other examples, DIMM 710 may be utilized in a 3U or 4U form factor. It is to be appreciated that the distance D between chips 718A, 718B may be at least the size of a same or similar size chip, but in other examples, it may be greater than or less than the size of a same or similar size chip. This configuration provides additional pathways for heat generated by chips 718A, 718B to dissipate throughout the PCB. In some examples, this arrangement has resulted in a decrease in overall temperature of DIMM 710 by at least 6°C to 8°C, but in other examples, the overall temperature of DIMM 710 can be decreased by greater than 6°C, greater than 7°C, or greater than 8°C. In still other examples, DIMM 710 may have a temperature reduction of less than 6°C.

As shown, PCB 712 may be comprised of a first width W1 and a second width W2. Second width W2 may be less than first width W1. All of chips 718A and 718B may be positioned on a portion of PCB 712 within second width W2, and in this example all of chips 718A and 718B are positioned on a portion of PCB 712 within first width W1. In other examples, some of first chips 718A or second chips 718B may be relocated positioned at a portion of PCB 712 in an area between first width W1 and second width W2. In still other examples, the overall width of DIMM 710 may be uniform, such that W1 and W2 are equal. PCB 712 may further include a height H1 configured to accommodate chips 718A, 718B thereon. In this example, DIMM 710 may include, without limitation, buffers 709a-709d, such as advanced memory buffers, which can help to compensate for signal deterioration by buffering and resending a signal. Buffers 709a-709d may be positioned in a row R4 directly below chips 718B.

Chip 707 may also be provided, which in this example may be a power management integrated circuit ("PMIC") chip. In this example, chip 707 is shown arranged in row R2 and positioned between groups of chips 718A, 718B that are respectively positioned on opposite sides of chip 707 and PCB 712. In some examples, chip 707 can help to regulate power supply, such as power for memory. Chip 707 can, in some examples, include multiple voltage regulators and control circuits.

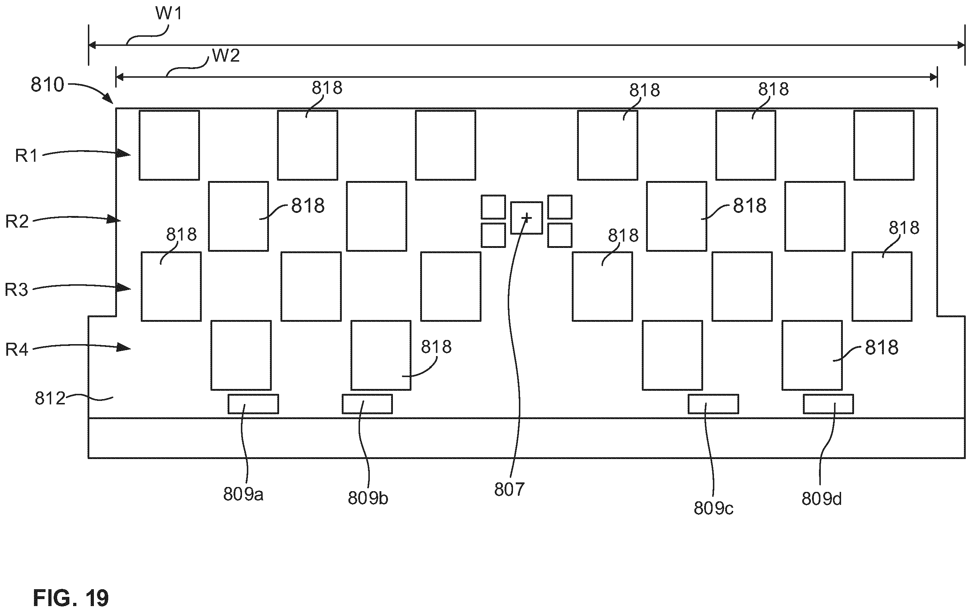

FIG. 19 provides another example pseudo-tall in-line memory module or DIMM 810, which includes a plurality of chips mounted on a PCB 812. In this example, PCB 812 includes four rows R1, R2, R3, and R4. Chips 818 are shown arranged across PCB 812 in a staggered pattern. For example, chips 818 in this example are arranged in a checkerboard pattern across PCB 812 and rows R1 through R4 to further distribute heat across PCB 812.

As shown, PCB 812 may be comprised of a first width W1 and a second width W2. Second width W2 may be less than first width W1. As shown, some chips 718 may be positioned at a portion of PCB 812 having first width W1 and other chips 818 may be positioned on a portion of PCB having second width W2. Chips 818 in first row R1 and third row R3 may be aligned with one another. Chips 818 in second row R2 and fourth row R4 may be aligned with one another. In other examples, the width of PCB 812 may be consistent, such that first width W1 and second width W2 are equal. In this example, although only one side of DIMM 810 is illustrated, it is to be appreciated that the opposed second surface of DIMM 810 may be identical and include a similar configuration of chips arranged across the second surface. In still other examples, the rear surface may differ and include no chips at all or a different configuration or arrangement of chips. In this example, DIMM 810 may include buffers 809a-809d, such as an advanced memory buffer, which can help to compensate for signal deterioration by buffering and resending a signal.

Chip 807, which in this example is a PMIC, may be further provided as part of DIMM 810. In this example, chip 807 may be shown arranged in row R2 and spaced apart from chips 818 so as to be a part of the staggered pattern of chips 818 in row R2. Chip 807 can be used to regulate power supply, such as power for memory. PMIC 807 may include multiple voltage regulators and control circuits.

The in-line memory modules 710, 810 can be used in any one of the thermal cooling systems described herein or variations thereof.

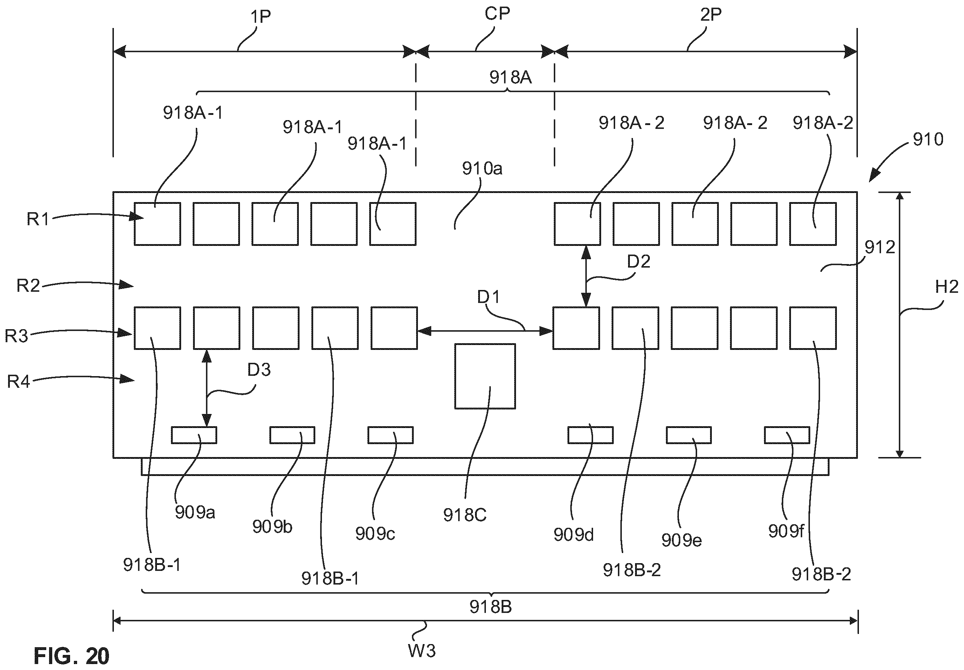

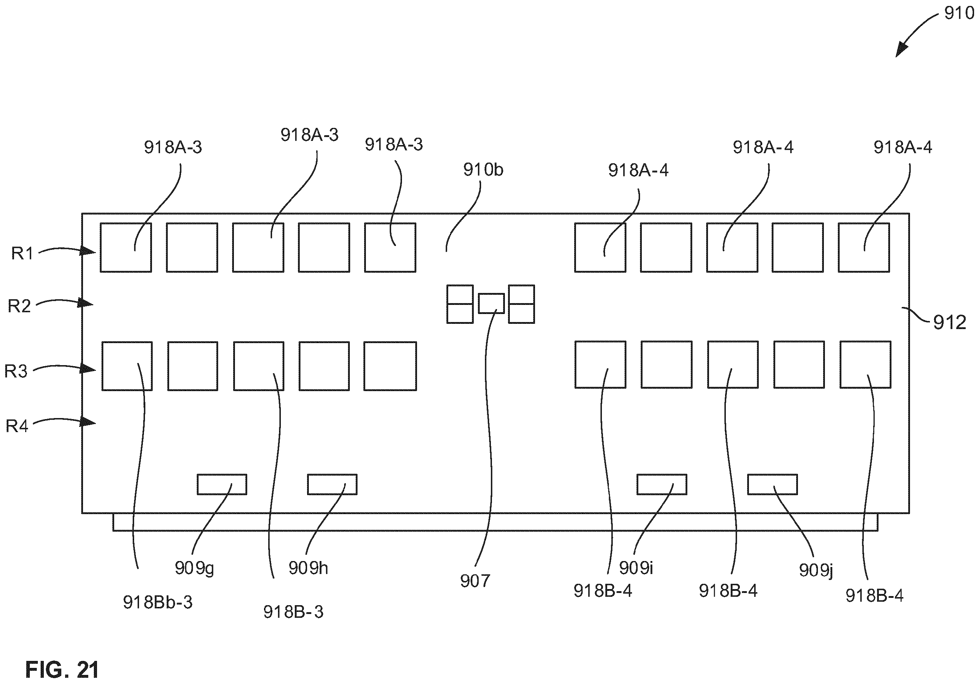

FIGS. 20-21 illustrate another example pseudo-tall in-line memory module, which in this example is DIMM 910. Front side 910a of DIMM 910, which is also front side of PCB 912, is depicted in FIG. 20. Rear side 910b of DIMM 910, which is also rear side of PCB 912, is depicted in FIG. 21. DIMM 910 illustrates an example where the DIMM is generally rectangular in shape and PCB 912 includes height H2 and width W3. As shown, and as compared to the prior examples of FIGS. 18-19, the overall width W3 of PCB 912 (and also DIMM 910) is the same. But, in other examples, such as shown in FIGS. 18-19, a DIMM may have varying widths. It is to be appreciated that in some examples, the size of the printed circuit boards of the DIMM or other type of in-line memory module to which chips, such as DRAM chips, are mounted in this and other examples described herein may be determined based on sizes that are established by a standards body. In some examples, the size and/or characteristics may be established by the Joint Electronic Device Engineering Council.

With reference first to front side 910a, DIMM 910 may be a 2U module that includes a plurality of chips 918A-1 and chips 918A-2 (collectively "chips 918A") and a plurality of chips 918B-1 and chips 918B-2 (collectively "chips 918B"), all of which are bonded or coupled to PCB 912. In this example, there are five chips 918A-1 and five chips 918A-2 for a total of ten chips in row R1. Similarly, there are five chips 918B-1 and five chips 918B-2 for a total of ten chips in row R3. In other examples, any number of chips in first row R1 and third row R3 can be implemented. DIMM 910 includes first row R1, second row R2, third row R3, and fourth row R4. Chips 918A, 918B may be memory chips, such as DRAM chips and the like, but any type of chips may be implemented in connection with DIMM 910.

Chips 918A and chips 918B may be arranged along a first portion 1P of front side 910a of PCB 912 and chips 918A-2 and chips 918B-2 may be arranged along second portion 2P of front side 910a of PCB 912. Chips 918A-1 and chips 918A-2, as well as chips 918B-1 and chips 918B-2 may be spaced apart from one another, such that a central portion CP of PCB 912 is formed between first portion 1P and second portion 2P. In this example, central portion CP can be defined in the space or distance D1 between chips 918A-1 in first row R1 and chips 918B-1 in third row R3. In some examples, the distance D1 may be at least the size of one of chips 918A-1 or chips 918A-2, but in other examples, the distance D1 may be greater than or less than the size of one of chips 918A-1, 918A-2.

As in the previous example, chips may be arranged across PCB 912 such that there are no chips positioned along second row R2 or fourth row R4. As shown in FIG. 20, second row R2 and fourth row R4 are depopulated and devoid of chips. Chips 918A in first row R1 and chips 918B in third row R3 are spaced apart from one another by a distance D2, which can aid in the thermal distribution and/or dissipation of heat generated by chips 918A, 918B in the space or distance D2 between first row R1 of chips and third row R3 of chips. As in previous examples, any type of chips can be implemented in connection with DIMM 910. For example, the majority of chips 918A, 918B in DIMM 910 may be IC chips, and in some examples may be memory chips, such as but not limited to dual random access memory chips.

Other types of chips may be incorporated into DIMM 910 and mounted to PCB 912. For example, chip 918C may be positioned in central portion CP between chips 918B-1 in third row R3 and chips 918B-2 in third row R3. In one example, chip 918C may be a multiplexed registered clock driver ("MRCD") chip. Chips 909a, 909b, 909c, 909d, 909e, 909f, which are collectively "chips 909a-909f", may also be mounted to PCB 912, and in this example, are positioned toward a bottom portion of PCB 912 and within first portion 1P and second portion 2P of PCB 912. In one example, chips 909a-909f may be multiplexed data buffer ("MDB") chips. In this example, six MDB chips 909a-909f are provided, but any number of chips or other types of chips can be provided. As shown, chips 909a-909f are spaced apart from chips 918B by a distance D3. In some examples, chip 918C and chips 909a-909f may collectively provide for multiplexing of a memory channel.

Rear side 910b of DIMM 910 and PCB 912 is depicted in FIG. 21. In this example, chips 918A-3 and chips 918A-4, arranged to extend across first row R1 of rear side 910b, and chips 918B-3 and chips 918B-4, arranged to extend across third row R3 of rear side 910b, may be identical to front side 910a and are not discussed in more detail. In this example, rear side 910b differs from front side 910a by including only four MDB chips 909g, 909h, 909i, 909j and instead of chip 918C, which in this example is an MRCD chip, chip 907 may instead be another IC chip 907, such as a microcontroller chip, such as a PIC chip. As shown, chip 907 may be arranged in central portion CP of PCB 912 along row R2, instead of fourth row R4 where chip 907 is located on front side 910a. In some examples, chip 907 can be used to regulate power supply, such as power for memory, and can optionally include multiple voltage regulators and control circuits.

Use of this pseudo-tall DIMM example configuration has shown a reduction of up to 10°C for the chip or DRAM that possesses the highest temperature in DIMM 1010, as compared to an equal number of closely-spaced chips in a DIMM configuration having a 1U form factor. In other examples, the reduction may be less than or more than 10°C.

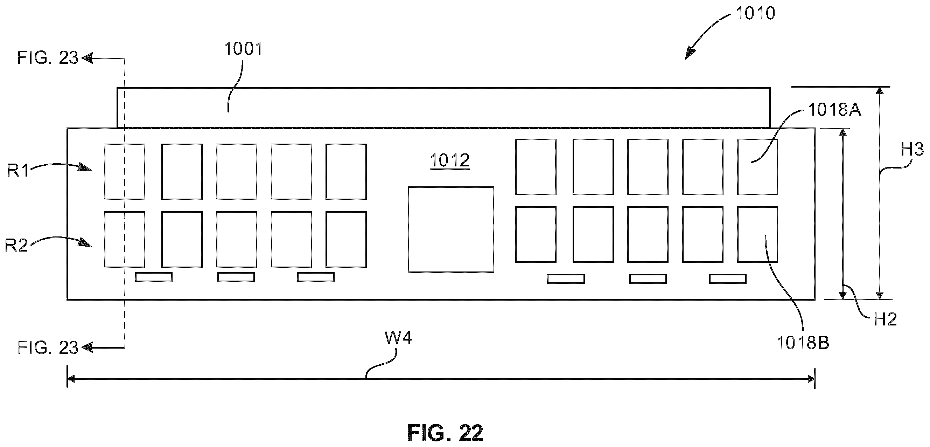

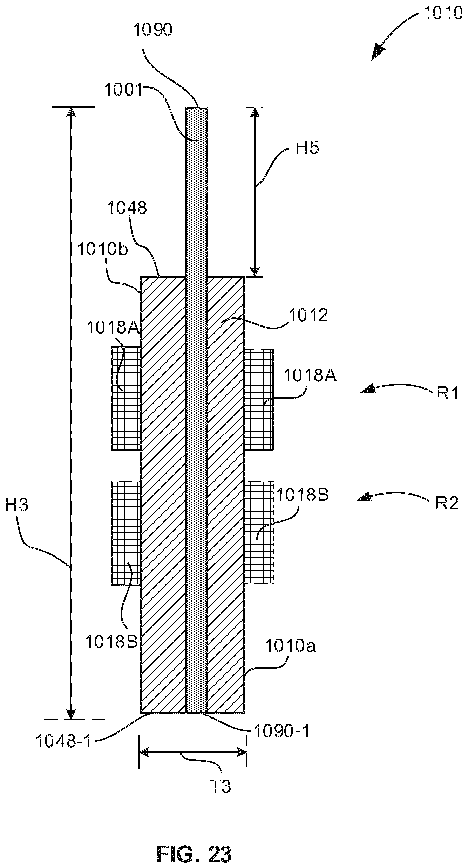

FIGS. 22-23 illustrate another example in-line memory module, which in this example is DIMM 1010. As shown in this example, DIMM 1010 may be a 1U form factor memory module, but in other examples, a 3U, 4U, or more can be implemented according to aspects of the disclosure. As shown, DIMM 1010 may have a first side 1010a and second side 1010b, with first and second sides 1010a, 1010b including a respective plurality of upper chips 1018A in first row R1 and a plurality of lower chips 1018B in a directly adjacent second row R2, all of which are coupled to PCB 1012. In this example, DIMM 1010 with integrated heat spreader may have an overall height H3, a width W4, and a thickness T3, as shown in FIGS. 22 and 23. In this example, PCB 1012 will have a width, which is also W4, height W2, and thickness, which is also T3. This example differs from previous DIMM or in-line memory modules disclosed herein due to the presence of heat spreader or heatsink 1001 that is integrated directly into PCB 1012. DIMM 1010 is shown standing alone, but may be coupled to a main board or mother board by a DIMM connector or other structure.

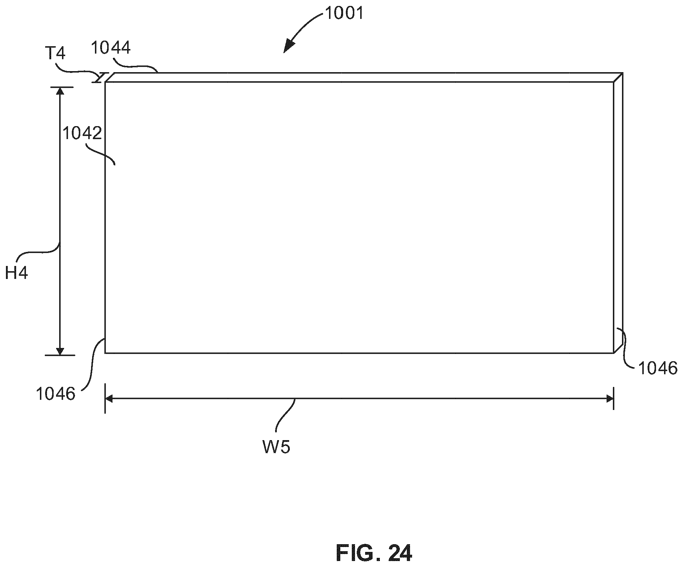

As shown in FIG. 24, heat spreader 1001 may be a sheet of thermally conductive material, and in some examples, may be a substantially planar sheet of material. Heat spreader 1001 may have first surface 1042, second surface 1044, and opposed side edge surfaces 1046 extending between first and second surfaces 1042, 1044. Heat spreader 1001 may further comprise a height H4, width W5 and thickness T4 that can be any desired height, width and thickness. In this example, width W5 of heat spreader 1001 may be less than width W4 of PCB 1012, and height H4 of heat spreader 1001 may be greater than height H2 of PCB 1012. In other examples, height H4 of heat spreader may be equal to or less than height H2 of PCB 1012. Heat spreader 1001 may be comprised of any thermally conductive materials, such as for example without limitation, copper, aluminum, diamond, or composite materials such as copper-molybdenum and copper-tungsten.

With reference back to FIG. 23, heat spreader 1001 is shown integrated into PCB 1012. As shown, a portion of heat spreader 1001 extends beyond a periphery of thee PCB 1012. In one example, heat spreader 1001 may extend beyond top edge surface 1048 of PCB 1012. For example, top edge 1090 of heat spreader 1001 may be positioned or spaced away from top edge 1048 of PCB 1012 by a length H5, which may be any desired distance. In some examples, H5 may range from 40 mm to 80 mm beyond top edge surface 1048 of PCB 1012, 40mm to 60 mm, 40mm to 50mm or 60 mm to 80 mm, or other ranges that may extend beyond 80 mm or below 40 mmm. In still other examples, top edge 1090 of heat spreader 1001 may extend a length H5 that is less than 40 mm or greater than 80 mm, depending on the space available for DIMM 1010 in the particular application for which DIMM 1010 is intended to be used. Heat spreader 1001 may also extend below top edge surface 1048 of PCB 1012 by any desired distance. In this example, bottom edge surface 1090-1 of heat spreader 1001 extends to bottom surface 1048-1 of PCB 1012.

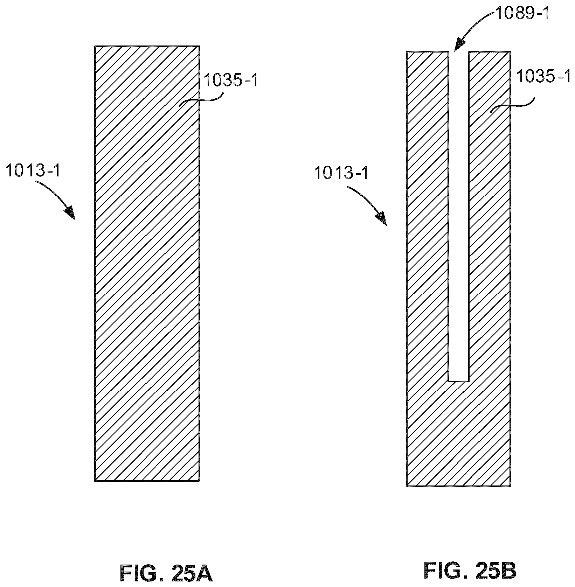

Integration of a heat spreader into a PCB can occur according to various methods. For example, heat spreader 1001 can be directly incorporated into PCB 1012 as part of or during the PCB manufacturing process. In one example, with reference to FIG. 25A, an in-progress PCB 1035-1 is shown that include a main body 1013-1, that may be comprised of several PCB layers that may include, without limitation, laminate, conductive sheets, plating and the like. In-progress PCB 1035-1 may be fully built-up circuitry, interlayer connections and the like, or only partially processed. As shown in FIG. 25B, a cavity 1089-1 can be formed within main body 1013-1 of in-progress PCB 1035-1, which is configured to receive a desired size and depth of heat spreader 1001-1. In-progress PCB 1035-1 can be configured such that the portion of PCB 1035-1 cut away from main body 1013-1 to form cavity 1089-1 contains no circuitry or the like and/or additional connections and/or processing can occur after cavity 1089-1 is created. In an example where some or all of the connections within in-progress PCB 1035-1 are created prior to creation of cavity 1089-1, a carrier layer or the like can be provided in the space forming the cavity. After cavity 1089-1 is created, a heat spreader may be inserted directly into cavity 1089-1 of in-progress PCB 1035-1. For example, with reference back to FIG. 24, heat spreader 1001 can be inserted into cavity 1089-1 of FIG. 25B. Cavity 1089-1 can be configured so that heat spreader 1001 will have an interference fit with cavity 1089-1 and in-progress PCB 1035-1. A thermal interface material can optionally be provided between heat spreader 1001 and in-progress PCB 1035-1 to help join and thermally couple a heat spreader to an interior surface of in-progress PCB 1035-1.

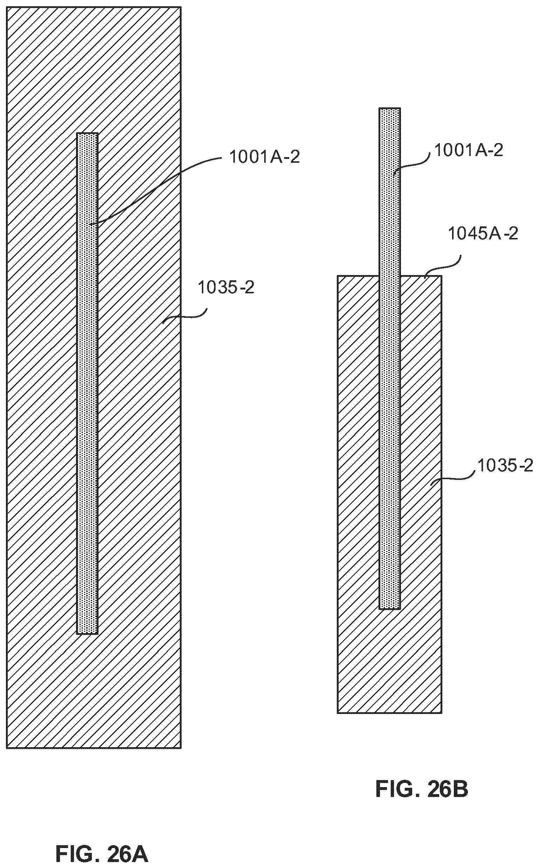

In other examples, a pre-fabricated heat spreader or heat spreader material may be formed during manufacture of the PCB, such that the heat spreader also functions as a carrier layer during manufacture. For example, as shown in FIG. 26A, a sheet of thermally conductive material 1001A-2 that will later become the heat spreader may be provided between layers and circuity to form in-progress PCB 1035-2. During manufacture of in-progress PCB 1035-2, sheet of thermally conductive material 1001A-2 can act as a carrier layer that supports other layers within the PCB before, during and/or after the PCB manufacturing process. As shown in FIG. 26B, during the manufacturing process, a portion of in-progress PCB 1035-2 can be cut away to form a top edge 1045A-2 of in-progress PCB 1035-2 to expose a portion of sheet of thermally conductive material 1001A-2 beyond a top surface of PCB 1035-2. Additional manufacturing of in-progress PCB 1035-2 and/or sheet of thermally conductive material 1001A-2 can optionally take place after the sheet of thermally conductive material is exposed. Alternatively, the process may be completed once portions of in-progress PCB 1035-2 are cut away.

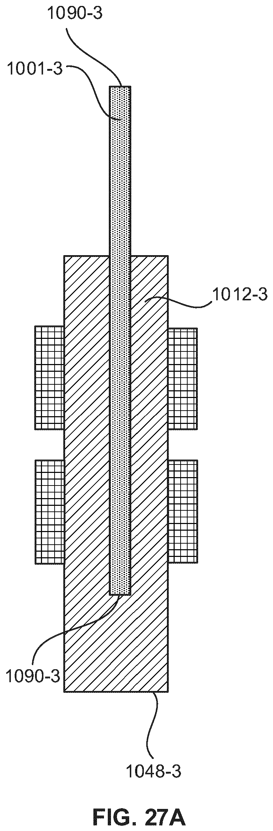

The shape and size of the heat spreader that will be positioned within the PCB can vary. FIG. 27A depicts another example, in which bottom edge surface 1090-3 of heat spreader 1001-3 does not extend to bottom edge surface 1090-3 of PCB 1012-3 and instead lies between top edge surface 1048-3 and bottom edge surface 1048-3. In this example, bottom edge surface 1048-3 extends a majority of a height of PCB 1012-3 in a vertical direction or a direction transverse to the direction of a main or mother board to which DIMM 1010-3 will be coupled.

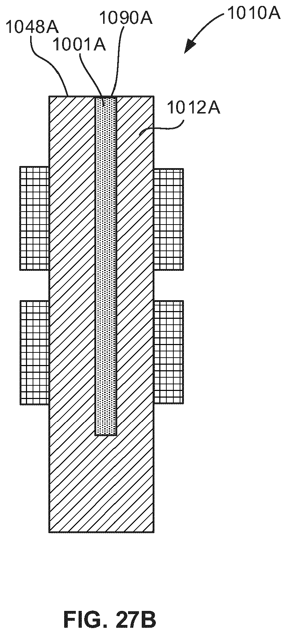

FIG. 27B depicts another example DIMM 1010A. In this example, instead of heat spreader 1001A extending beyond top edge surface 1048A of PCB 1012A, top edge 1090A of heat spreader 1001A and top edge surface 1048A of PCB 1012A may be aligned with one another so as to form an overall continuous top edge surface of DIMM 1010A.

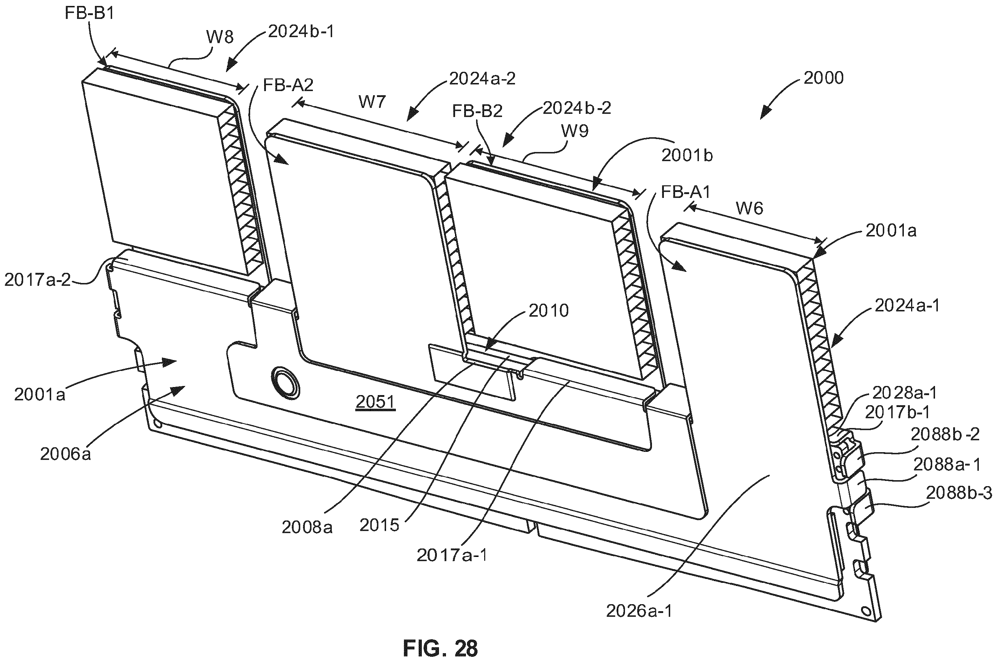

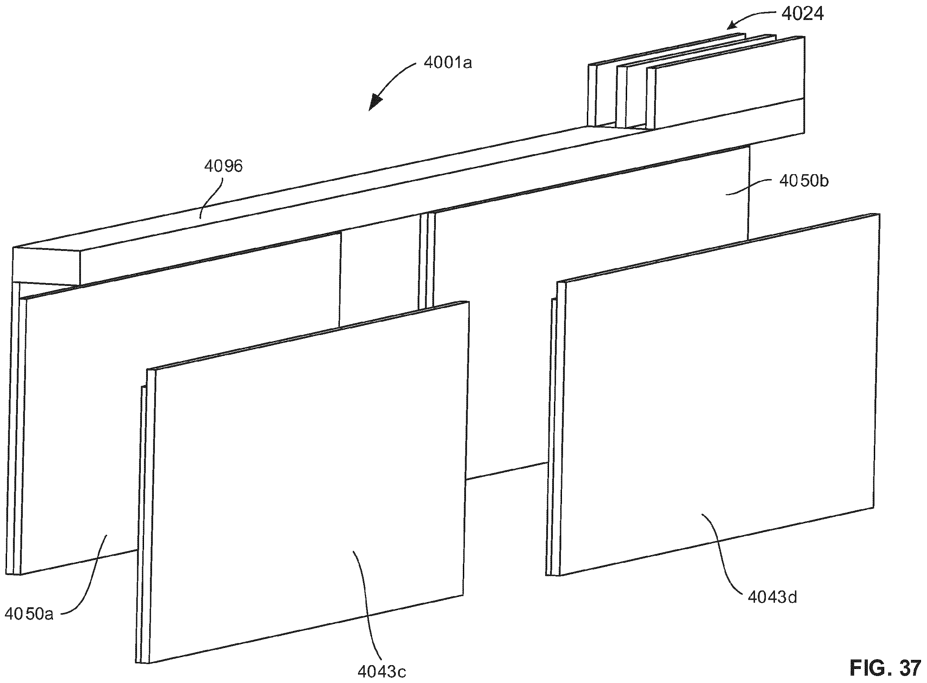

FIGS. 28-45 provide another series of example cooling systems for in-line memory modules, including systems implementing various types of heatsinks with improved fin structures. The fin structures disclosed herein can aid in thermal dissipation of heat from components of the in-line memory module and/or components in a larger system to which the in-line memory module is connected. In some examples, the fin structures can facilitate the movement of heat in a direction away from the main board to which the in-line memory module is connected.

FIGS. 28-31C illustrate an example system 2000 and components thereof. System 2000 may include an in-line memory module with at least one heat sink coupled to the in-line memory module to aid in thermal dissipation of heat generated by at least chips and/or other components of the in-line memory module. As in prior examples, in-line memory module may be any type of in-line memory module and may comprise, but is not limited to a DIMM, SODIMM, and RIMM. In this example, system 2000 includes DIMM 2010 and two heat sinks coupled to DIMM: heatsink 2001a and heatsink 2001b (collectively "heatsinks 2001a, 2001b"). In some examples, clip 2051 may be used to couple and/or secure heatsinks 2001a, 2001b and DIMM 2010 together.

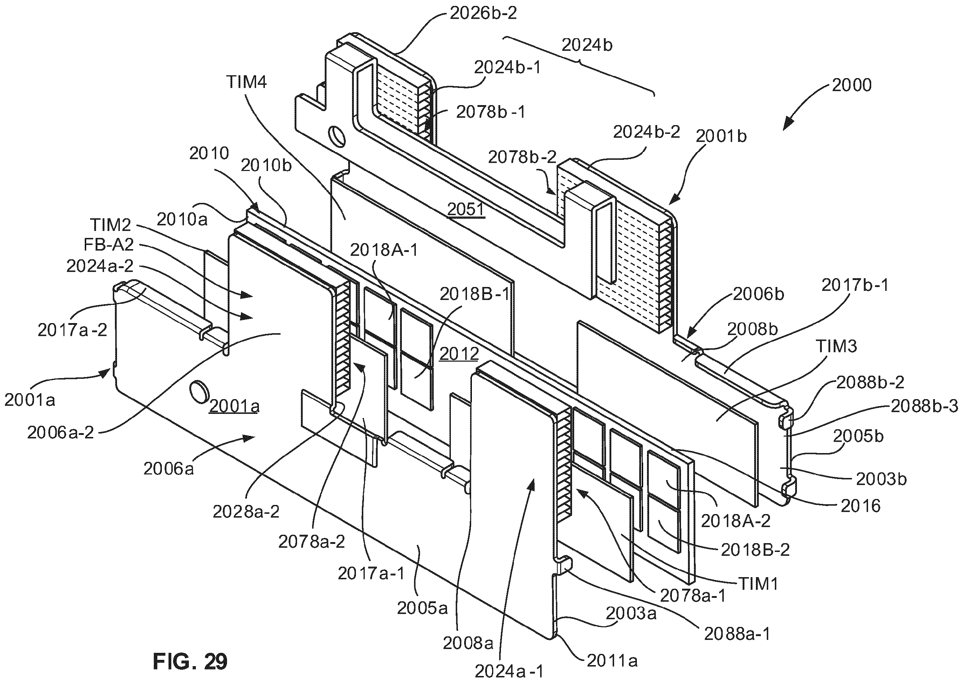

DIMM 2010 can take on various configurations and, in this example, includes PCB 2012 with multiple chips coupled to PCB 2012. As shown in FIG. 29, a plurality of chips may be disposed at first side 2010a and second side 2010b of DIMM 2010, but in other examples, chips may be provided at only one side of DIMM 2010. DIMM 2010 may have a 1U form factor, but in other examples, other form factors, such as, but not limited to 2U or 3U form factor may be implemented within system 2000. The chips may be further coupled to and arranged across PCB 2012 in similar arrangements disclosed in prior examples, such as DIMM 910 of FIGS. 20 and 21, as well as possess similar features. One or more heatsinks may be coupled to DIMM 2010. In this example, with reference still to FIG. 29, heatsink 2001a may be coupled to first side 2010a of DIMM 2010 by a TIM, including by a sliding TIM, such as previously described herein. The TIM may be provided over any portion of first and second sides 2010a, 2010b of DIMM 2010. In this example, first TIM layer TIM1 overlies chips 2018A-2 and 2018B-2 in respective first row DR1 and second row DR2. Second TIM layer TIM2 overlies chips 2018A-1 and 2018B-1 in respective first row DR1 and second row DR2. Heatsink 2001b may be similarly coupled to a second side 2010b of DIMM 2010 by a TIM, including a sliding TIM, such as previously described herein. For example, a third TIM layer TIM3 and fourth TIM layer TIM4 may overlie chips, if any, mounted to the surface of second side 2010b. It is to be appreciated that the TIM layers can be applied to either surfaces of chips 2018A-2 and 2018B-2 or to a surface of heat spreader 2001a that will overlie chips 2018A-1 and 2018B-1.

Heatsink 2001a may be structurally similar to heatsink 2001b, and in this example, heatsinks 2001a, 2001b may be identical. In other examples, one or more features of heatsinks 2001a and 2001b may differ. Heatsink 2001a may include main body 2006a that may be rectangular in shape with one or more integrated and thermally conductive fins, such as fin 2024a-1 and fin 2024a-2 (collectively referred to as "fins 2024a-1, 2024a-2" or "fins 2024a"). In this example, the rectangular shape of heatsink 2001a can correspond to the rectangular shape of DIMM 2010, but heatsink 2001a can take on other shapes and sizes. For example, heatsink 2001a may be configured to have a more rounded profile than DIMM 2010, or may not fully extend beyond edges of DIMM 2010, or various other structural variations. Heat sink 2001b similarly includes main body 2006b that may be rectangular in shape with one or more conductive fins, such as fins 2024b-1, 2024b-2.

Conductive fins of heatsinks 2001a, 2001b can comprise various configurations and any number of conductive fins and any portion of conductive fins can be formed with heatsinks 2001a, 2001b. In this example, heatsink 2001a includes two fins: fin 2024a-1 and fin 2024a-2, but in other examples, one fin or more than two fins can be implemented. Fins 2024a may have a fin body FB-A1 that may be elongated and extend vertically in a direction away from top edge 2008a of main body 2006a of heatsink 2001a. As shown in FIGS. 28, 29 and 30, fin 2024a-1 may have a fin body FB-A1with an outer surface 2026a-1 and an interior surface 2028a-1. Similarly fin 2024a-2 may have a fin body FB-A2 with an outer surface 2026a-2 and an interior surface 2028a-2. In these examples, fin bodies FB-A1, FB-A2, FB-B1 may be in the shape of a rectangle, where a length of the rectangle is greater than its width, but in other examples, any shape can be implemented. Further, in this example, fin 2024a-2 may be formed integrally with heatsink 2001a, but in other examples, fin 2024a-2 may be separately manufactured and coupled to heatsink 2001a.

Heatsink 2001b may similarly include two fins: fin 2024b-1 and fin 2024b-2 (collectively referred to as "fins 2024b"), but in other examples, one fin or more than two fins can be implemented. Fins 2024b may have an elongated body that extends vertically in a direction away from top edge 2008b of main body 2006b of heatsink 2001b. Similarly to fins 2024a-1, fin 2024b-1 may have a fin body with an outer surface 2026b-1 and an interior surface 2028b-1. Similarly fin 2024b-2 may have a fin body with an outer surface 2026b-2 and an interior surface 2028b-2.

Fins may be identical in one or more of size, shape, and material. In this example, the overall height of fins 2024a, 2024b are the same, but the widths may differ. For example, as shown in FIG. 28, fin 2024a-1 has a width W6 that is less than width W7 of fin 2024a-2. Similarly, fin 2024b-1 has a width W8 that is less than width W9 of fin2024b-2. In other examples the widths W6, W7 of fins of heatsink 2001a may be the same. Similarly, widths W8, W9 of fins of heatsink 2001b may be the same.

Fins 2024a of heatsink 2001a may be spaced apart from one another along a length of main body 2006a, with fin 2024a-1 positioned closest to edge 2011a of heatsink 2001a, and in this example aligned with edge 2011a of heatsink 2001a. As seen in FIG. 29, thermally conductive fins 2024b-1, 2024b-2 (collectively referred to as "fins 2024b") of heatsink 2001b may also be spaced apart from one another along length of main body 2006b. In this example, the arrangement of thermally conductive fins 2024a-1 and 2024a-2 on heatsink 2001a along main body 2006a creates an overall heatsink shape that is in the shape of the letter "F". Similarly, the arrangement of thermally conductive fins 2024b-1, 2024b-2 along main body 2006b, create an overall heatsink shape that is in the shape of the letter "F". But, in other examples, the type of fins and location can change, which would accordingly modify the overall profile shape. Heatsinks 2001a, 2001b can be comprised of thermally conductive material, including without limitation, copper, aluminum, and the like.

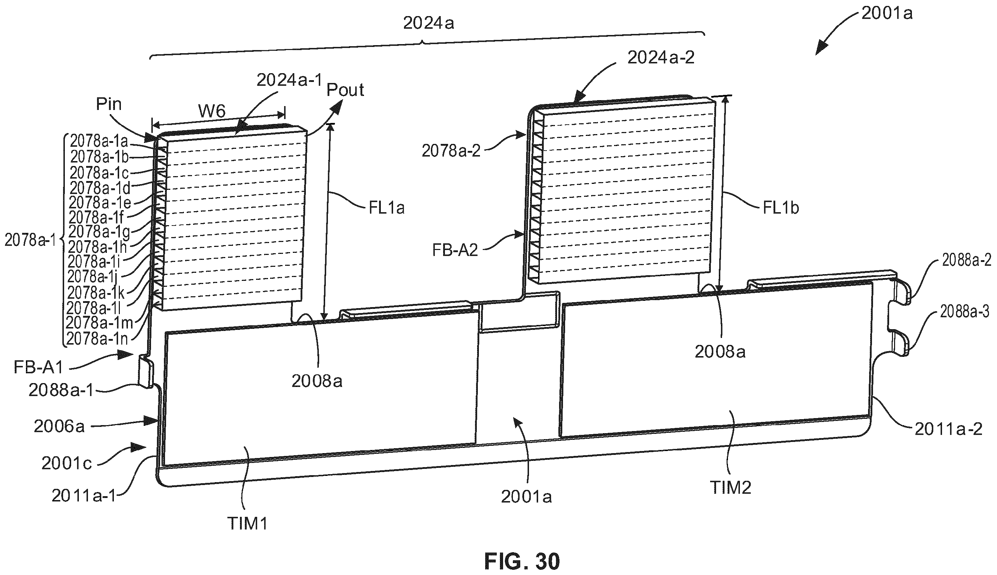

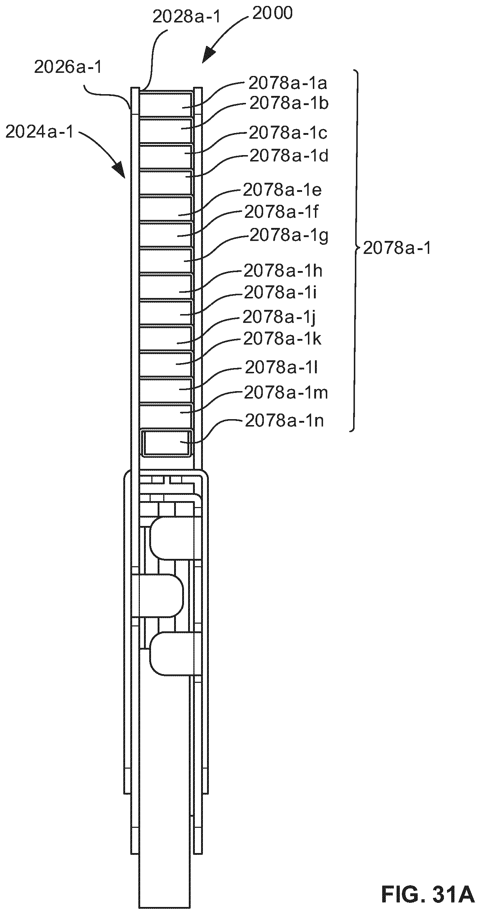

One or more passageways or channels may optionally be provided and form part of conductive fins in system 2000. The passageways may be integrally formed as part of the fin or coupled to the fin structure forming heatsink 2001a, 2001b. Fins 2024a, 2024b are shown in this example, as each including a plurality of channels. Referring to FIGS. 30 and 31A and first fin 2024a-1 of heatsink 2001a, fin 2024a-1 includes a plurality of channels extending across width W6 of fin 2024a-1. Any number of channels can be provided and, in this example, there are fourteen channels: 2078a-1a, 2078a-1b, 2078a-1c, 2078a-1d, 2078a-1e, 2078a-1f, 2078a-1g, 2078a-1h, 2078a-11, 2078a-1j, 2078a-1k, 2078a-11, 2078a-1m, and 2078a-1n, which will be collectively referred to as channels 2078a-1. Channels 2078a-1 may extend across a width W6 of fin 2024a-1. Similar channels 2078a-2 may extend across a width W7 of fin 2024b-1. Channels 2078a-1 may be positioned one on top of the other, such that the channels are uniformly distributed along a length of fin 2001a, but in other examples, the channels may not be evenly distributed. Fin 2024a-2 may also comprise a plurality of channels 2078a-2, which in this example, comprise fourteen channels. Heatsink 2001b is similar to heatsink 2001a in this example, and also further includes fins 2024b-1, 2024b-2 that have different widths W8, W9, and each fin 2024b-1, 2024b-2 having fourteen channels 2078b-1, 2078b-2. The channels or passageways on heatsinks 2001a, 2001b can allow for an expanded heatsink surface area in which to distribute heat. In some examples, the velocity of air as it flows through the channels can also be increased, which can enhance cooling, as well as providing extended surfaces for cooling of the overall in-line memory module.

FIG. 31A illustrates a side view of system 2000 of FIG. 28. Channels 2078a-1 may be positioned one on top of the other along length FL of fin 2024a-1. Channels 2078a-1 may be open at both ends, such that there is a passageway entrance and a passageway exit through which air can flow. Each channel 2078a-1 may have a rectangular profile, but in other examples, channels 2078a-1 can have any profile. In this example, fins 2024a-1, 2024a-2 of heatsink 2001a and fins 2024b-1, 2024b-2 of heatsink 2001b may be similar and include the same number and type of channels, but in other examples, one or more of fins 2024a-1, 2024a-2, 2024b-1, 2024b-2 may include a different fin structure, including with or without channels, or no fins altogether.

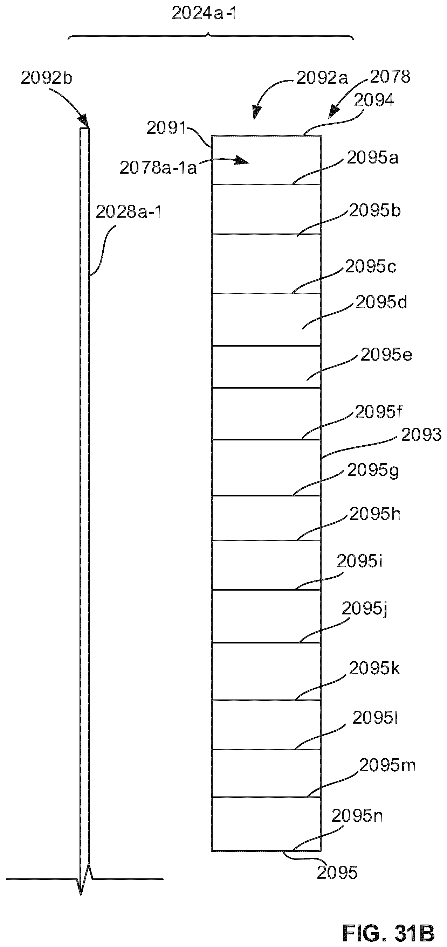

Thermally conductive fins with passageways can be manufactured according to various methods. In one example, the passageways may be separately manufactured and then coupled to a fin support structure. For example, with reference to FIG. 31B, fin 2024a-1 may further comprise a channel assembly 2092a and a fin support 2092b. As shown, fin support 2092b may be a portion of fin 2024a-1 that extends upwardly from the edge 2011a of heatsink 2001a and forms the overall elongated shape of fin 2024a-1. Channel assembly 2092a may comprise channels 2078a-1 formed as a separate assembly, which may then be coupled to fin support 2092b. Channel assembly 2092a may be defined by an interior wall 2091 and an exterior wall 2093 that enclose an interior space of channel assembly 2092a, an outermost top wall 2094 and an outermost bottom wall 2095. A plurality of divider walls 2095 may be provided along the width and length of channel assembly 2092a, so as to form a plurality of channels therethrough. For example, channel 2078a-1a may be defined by a portion of interior wall 2091, a portion of exterior wall 2093, top wall 2094 and divider wall 2095a. Each of the remaining channels are similarly formed by the inclusion of one of divider walls 2095b-2095n. In other examples, the channels and/or portions of the channel can be integrally formed with heatsink 2001a.

Heatsinks 2001a, 2001b in system 2000 may be optionally configured to interlock with one another. For example, heatsinks 2001a, 2001b may each include structural features that interlock or form interlocking features when heatsinks 2001a, 2001b are joined together. In this example, as will be described in more detail, interlocking components of heatsinks 2001a, 2001b may include without limitation, side tabs, ledges, and a fin arrangement to provide for an interlocking arrangement. In other examples, one or none of tabs, ledges, a fin arrangement, or any other interlocking structural feature is required, such that heat sinks 2001a, 2001b may instead be adjacent one another without including interlocking components.

When oriented to face toward and join with one another, with reference back to FIG. 29, heatsinks 2001a, 2001b extend around at least a portion of DIMM 2010. As shown, outer surface 2005a of heatsink 2001a faces away from DIMM 2010 and interior surface 2003a of heatsink 2001a faces toward DIMM 2010. Similarly, outer surface 2005b of heatsink 2001b faces away from DIMM 2010 and interior surface 2003b of heatsink 2001b faces toward DIMM 2010.

With reference back to FIG. 28, fin 2024b-2 of heatsink 2001b may be positioned between fin 2024a-1 and fin 2024a-2 of heatsink 2001a. Fin 2024a-2 is shown positioned between fin 2024b-1 and fin 2024b-2. This configuration provides for an interlocking arrangement where fin 2024a-2 is positioned between and directly adjacent fins 2024b-1 and 2024b-2, such that heatsink 2001a and heatsink 2001b are inhibited from moving in a lateral direction along a length of heatsinks 2001a, 2001b.

Heatsinks 2001a, 2001b may further comprises ledges that extend perpendicular to a direction in which fins 2024a, 2024b extend. For example, as shown in FIG. 29, heatsink 2001a includes ledges 2017a-1, 2017a-2 and heatsink 2001b includes the same ledges, including ledge 2017b-1 shown in this view. Heatsinks 2001a, 2001b may further include any number of ledges or no ledges at all. Referring back to FIGS. 28-29, when joined together, ledges 2017a-1, 2017a-2, 2017b-1 can extend across the top surface of DIMM 2010. As shown, this allows for at least a portion of heatsinks 2001a, 2001b to overlie top surface 2015 of DIMM 2010.

With reference to FIG. 30, an interior view of heatsink 2001a and first TIM layer TIM1 and second TIM layer TIM2 are shown. Heatsink 2001a may include side tabs that extend in a direction perpendicular to the outermost edge surfaces of heatsink 2001a. For example, at first edge 2011a-1, side tab 2088a-1 extends in a direction perpendicular to the major surface of heatsink 2001a. At opposed second edge 2011a-2 of heatsink 2001a, two side tabs 2088a-2, 2088a-3 extend in a direction perpendicular to the major surface of heatsink 2001a. Similarly, as shown in FIG. 29, heatsink 2001b is a mirror image of heatsink 2001a and may also include tabs 2088b-1, 2088b-2, 2088b-3. The tabs on heatsinks 2001a, 2001b are configured to interlock with one another when heatsinks 2001a, 2001b are joined together. For example, as shown in FIG. 28, tab 2088a-1 of heatsink 2001a is positioned between tabs 2088b-2, 2088b-3 of heatsink 2001b, such that heatsinks 2001a, 2001b are inhibited from movement in a vertical direction that is perpendicular to the width or length of the primary body of DIMM 2010.

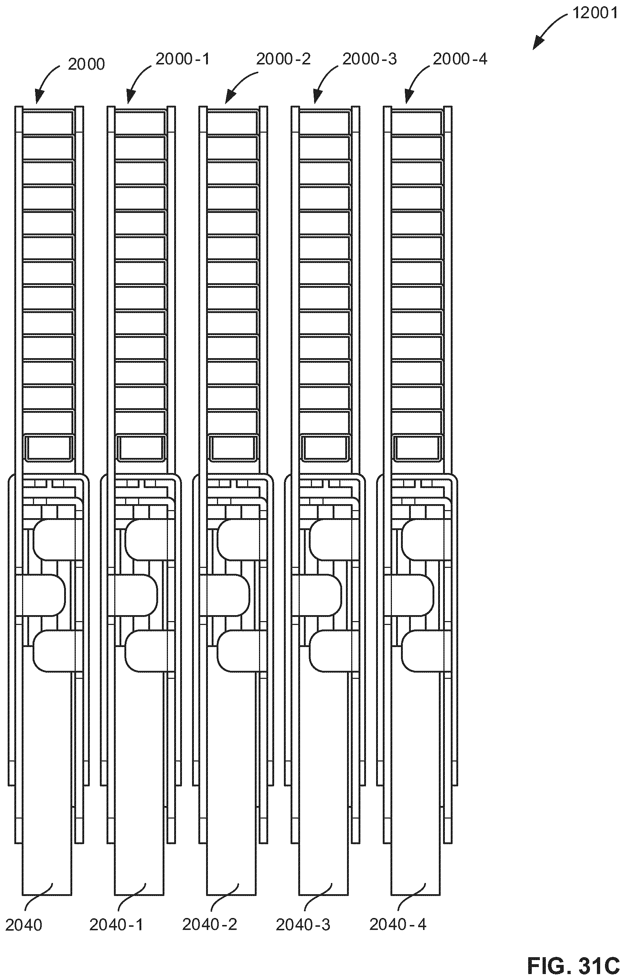

FIG. 31C illustrates system 12001, which includes multiple systems for thermal management of in-line memory modules, including system 2000, as well as additional systems 2000-1, 2000-2, 2000-3, 2000-4 that may be identical to system 2000 and are not described in more detail. As shown, systems 2000, 2000-1, 2000-2, 2000-3, and 2000-4 may be directly adjacent one another and coupled to corresponding DIMM connectors 2040, 2040-1, 2040-2, 2040-3, 2040-4, which can be further coupled to a main or mother board. This system differs from system 101 of FIGS. 1-17 to the extent that individual and separate heat spreaders are used to thermally conduct heat from each DIMM within the respective systems 2000, 2000-1, 2000-2, 2000-3, 2000-4.

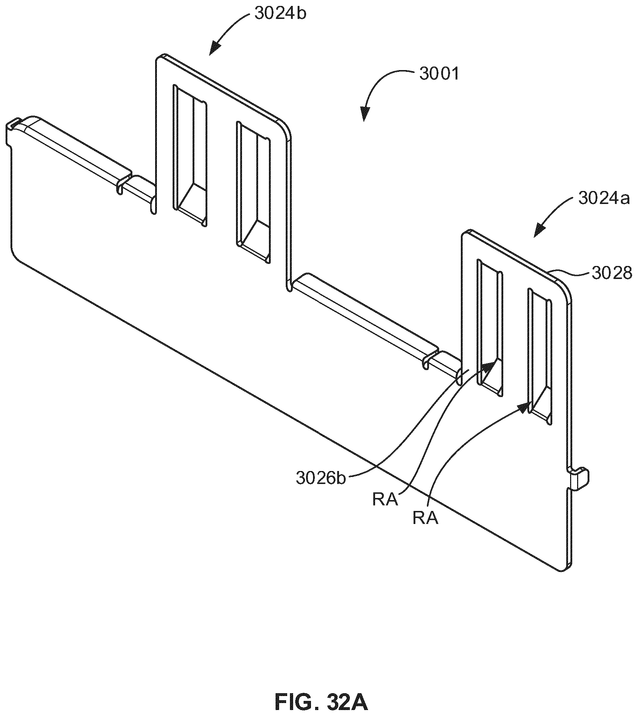

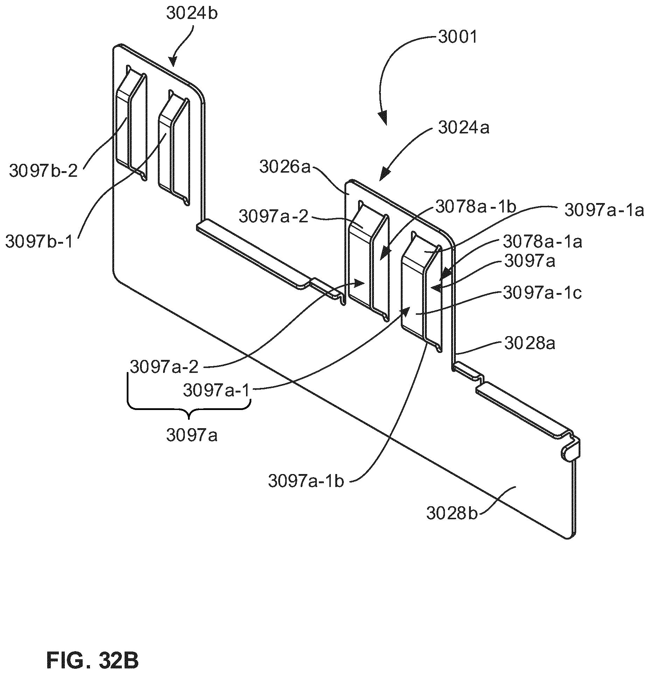

FIGS. 32A-32B illustrate an alternative heatsink 3001. In this example, heatsink 3001 is similar to heatsinks previously disclosed, except for the structure of fins 3024a and 3024b and particularly the configuration of fins with protrusions. As shown, fin 3024a includes an interior surface 3026a, an exterior or outer surface 3026b, and one or more integrally formed protrusions 3097a-1, 3097a-2 that form air passageways or channels 3078. As shown, a portion of fin 3024a may be manufactured so as to form a first protrusion 3097a-1 and a second protrusion 3097a-2 (collectively referred to as "protrusions 3097a"). In one example, protrusions 3097a may be formed by punching a desired shape for each of the protrusions 3097a. In one example, protrusion 3097a-1 has two angled side edges 3097a-1a and 3097a-1b, as well as an edge 3097a-1c extending between two angled side edges 3097a-1a and 3097a-1b. This can result in protrusion 3097a-1 2 that extends away from outer surface 3026b of fin 3024a, as well as recessed areas RA, shown in FIG. 32A, extending away from outer surface 3026b of fin 3024a. This creates a channel or passageway 3078 through protrusions 3097a-1, 3097a-2. Fin 3024b may similarly include first and second protrusions 3097b-1, 3097b-2. In this example, protrusions are shown integrally formed as part of heat sink 3001, but in other examples, protrusions can be separately manufactured and coupled to heatsink 3001. Heatsink 3001 allows for an increased heatsink area in which heat may spread or be distributed away from chips in a DIMM to which heatsink will be coupled. The configuration of heatsink 3001 can further enhance cooling by providing passageways for air to pass through and aid with overall cooling in an in-line memory module system.

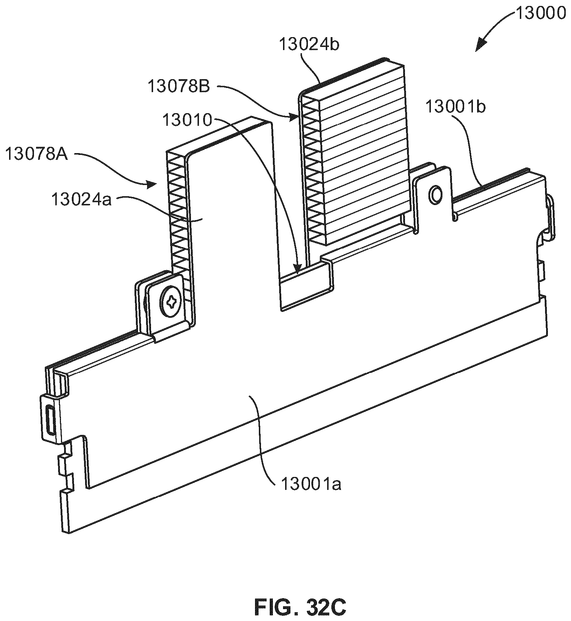

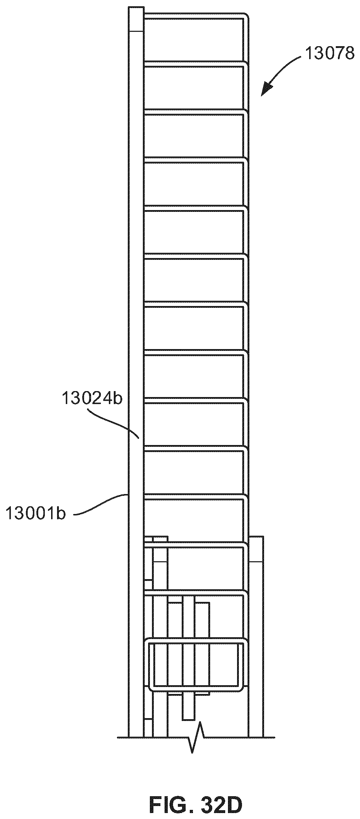

FIGS. 32C-32D illustrate another in-line memory module system 13000 that includes inline memory module, such as DIMM 13010, first heatsink 13001a and second heatsink 13001b coupled together. First and second heatsinks 13001a, 13001b may differ from heatsinks previously disclosed to the extent that heatsink 13001a, 13001b each only include one fin. For example, first heatsink 13001a includes only one fin 13024a with channels and second heatsink 13001b, which is identical to first heatsink 13001a, includes only one fin 13024b with channels 13078. FIG. 32D illustrates a side view of a portion of heat sink 13001b and channels 13078 that extend along each fin 13024b.

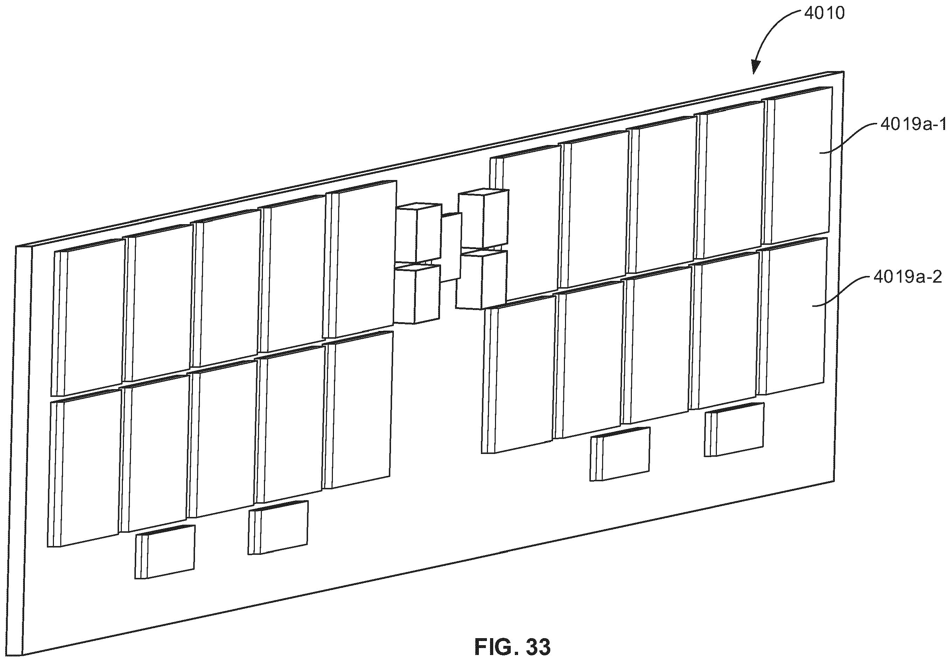

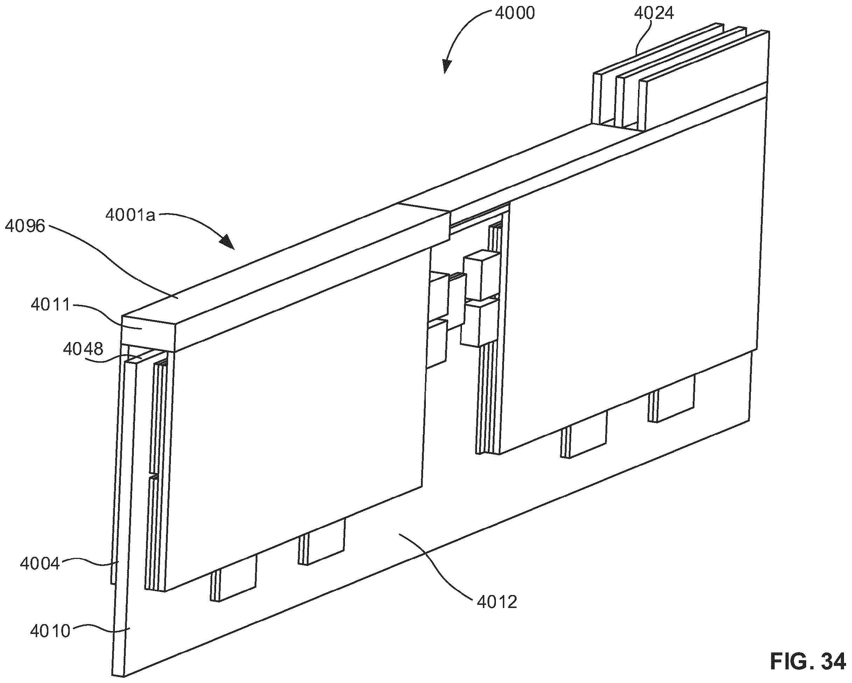

FIGS. 33-39 illustrate another example system 4000 and components of system 4000. Turning first to FIG. 33, an in-line memory module is shown, which in this example may be DIMM 4010, but as previously discussed, the in-line memory module can be any in-line memory module, including a SIMM. As shown and as in previous examples, DIMM 4010 includes multiple chips 4019a-1 and 4019a-2 arranged in rows. FIG. 34 illustrates system 4000 that includes DIMM 4010 and an alternative heatsink 4001a. As shown, heatsink 4001a includes an elongated base 4096 that overlies a top edge 4048 of PCB 4012 of DIMM 4010. In this example, PCB 4012 of DIMM 4010 is shown extending beyond an outermost side edge of heatsink 4001, but in other examples, outermost edge 4011 of heatsink 4001a may be aligned with or extend beyond outermost edge 4004 of PCB 4012 of DIMM 4010.

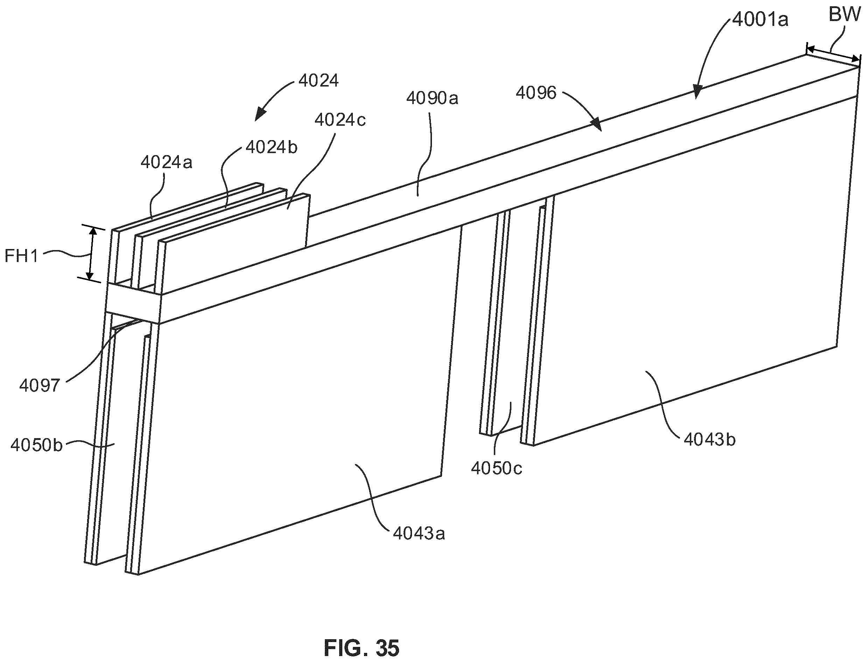

FIG. 35 illustrates heatsink 4001a standing alone. Heatsink 4001a may be configured to be similar in shape and size to the shape and size of a DIMM, such as DIMM 4010 shown in FIG. 34. In this example, heatsink 4001 may include an elongated base 4096 that has a base length BL and a base width BW. In one example, base length BL extends across and overlies a majority of a length of a major surface of DIMM 4010. Base width BW may be significantly smaller than base length BL, as well as slightly wider than a DIMM width DW of DIMM 4010.

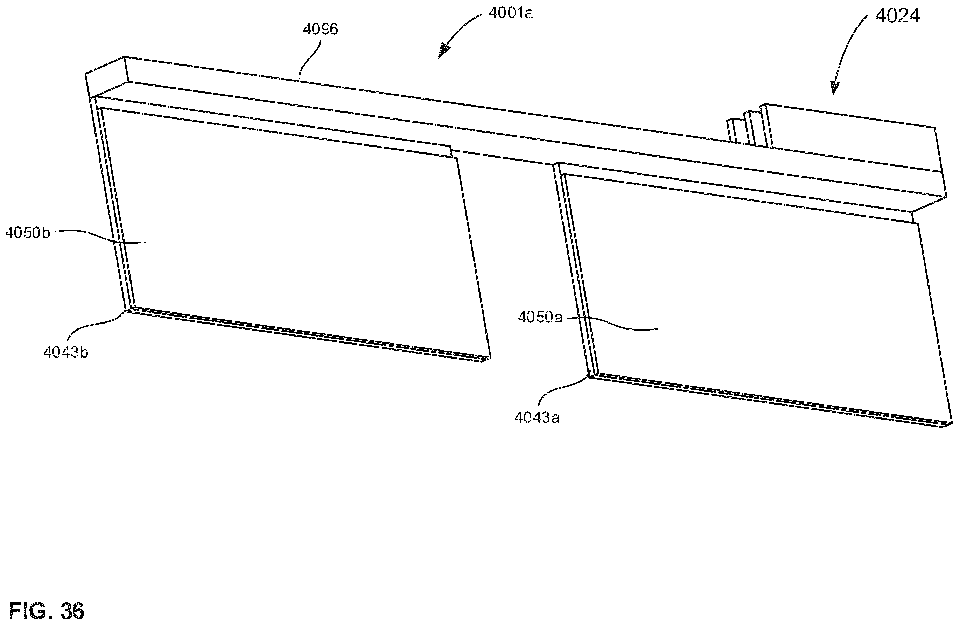

Heatsink 4001a may include any number of thermally conductive fins. In this example, heatsink 4001a includes at least three elongated fins 4024a, 4024b, 4024c, collectively fins 4024, that extend along a portion of base 4096. Fins 4024 extend upwardly and away from top surface 4090a of heatsink 4001a. Four thermally conductive panels 4043a, 4043b, 4043c, 4043d extend away from bottom surface 4097 of base 4096. As shown in FIGS. 36-37, panel 4043a and panel 4043b may be removably attached to base 4096. In some examples, it may be desired to only include two conductive panels, such as panels 4043c, 4043d and to not include panels 4043a, 4043b. When desired, panels 4043a, 4043b can be coupled to base 4096 using any known means. For example, panels 4043a, 4043b can be joined by a thermal adhesive or otherwise mechanically attached to base 4096, such as by the use of screws, or channels in base 4096 that allow panels 4043a, 4043b to slide therein. In still other examples, panels 4043a, 4043b are not removable, such that heatsink 4001a forms a homogeneous and integral unit. In this example, conductive fins 4024 may be formed from the same material as conductive panels, but in other examples, the materials comprising conductive fins 4024 may differ.

Layers of slidable TIM may be attached to conductive panels 4043a, 4043b, 4043c, 4043d to allow for heatsink 4001a to more easily overlie DIMM 4010. For example, TIM layer 4050a may be attached to panel 4043a, and TIM layer 4050b may be attached to panel 4043b, TIM layer 4050c may be attached to panel 4043c, and TIM layer 4050d may be attached to panel 4043d.

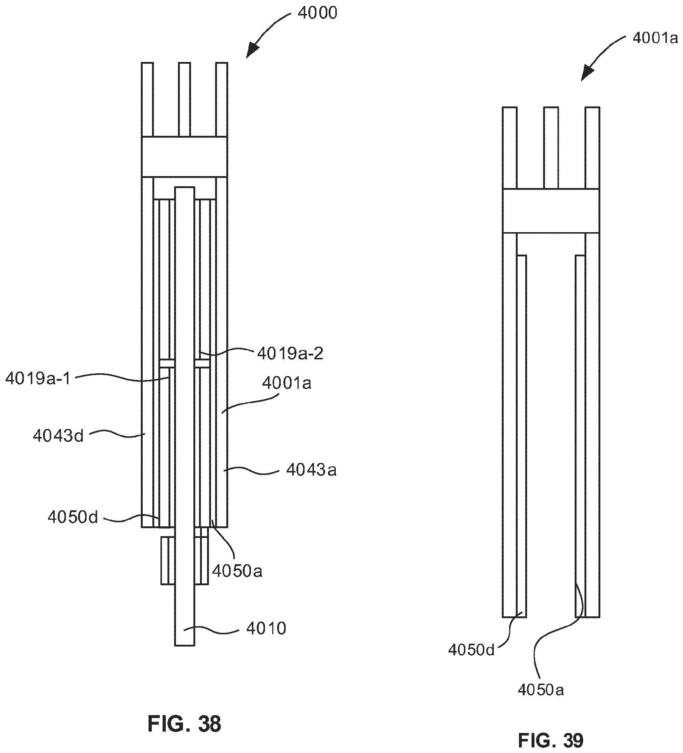

The height of fins 4024 can be any desired height to accommodate use of system 4000 in a particular application, such as for use with a space-limiting application or piece of equipment that requires a low profile in-line memory module. In one example, height FH1 of fins 4024 may be less than the height of traditional fins, including those previously disclosed herein, to allow for a compact DIMM 4010. A side view of system 4000 is seen in FIG. 38. In this view, heatsink 4001a and panels 4043a, 4043d are shown extending at least around a portion of DIMM 4010, including chips 4019a-1, 4019a-2, and TIM layers 4050a, 4050d. A side view of heatsink 4001a standing alone with TIM layers 4050a, 4050d is shown in FIG. 39.

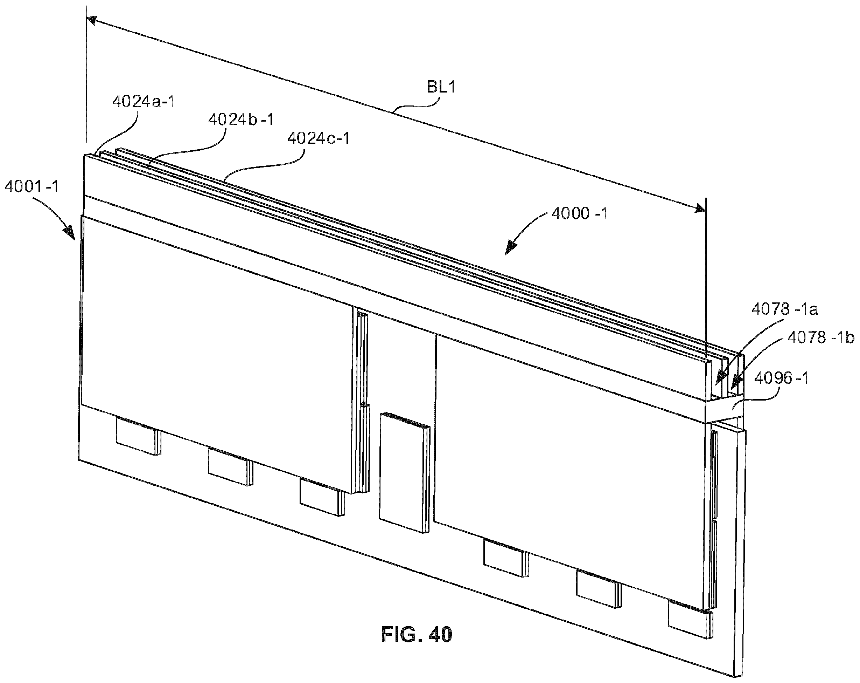

FIG. 40 illustrates another system 4000-1 that includes an in-line memory module and a heatsink 4001-1 that includes one set of thermally conductive fins. In this example, there are three conductive fins 4024a-1, 4024b-1, 4024c-1. Unlike the prior example, fins 4024a-1, 4024b-1, 4024c-1 extend along an entire length BL1 of base 4096-1. This further creates elongated channels, such as first channel 4078-1a between conductive fin 4024a-1 and fin 4024b-1, as well as a second channel 4078-1b between fin 4024b-1 and fin 4024c-1.

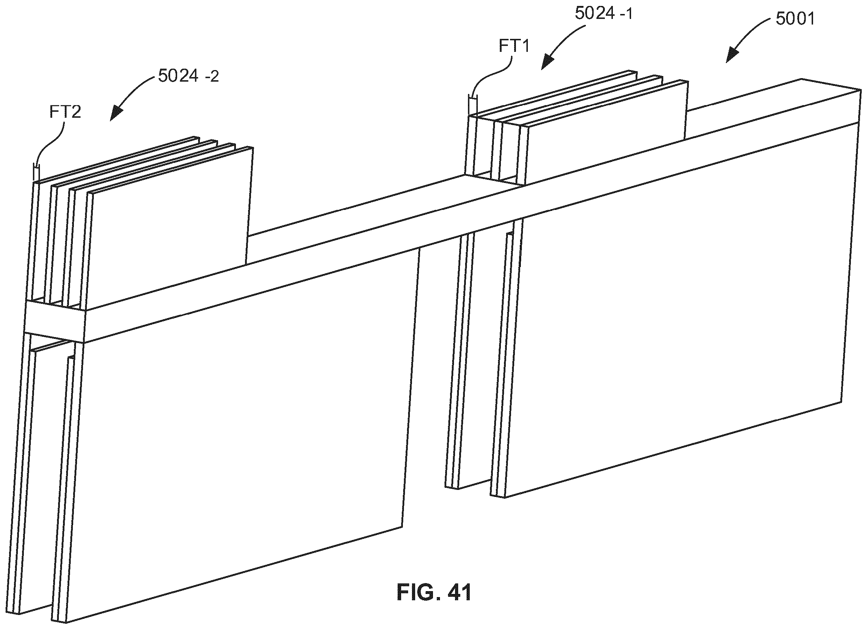

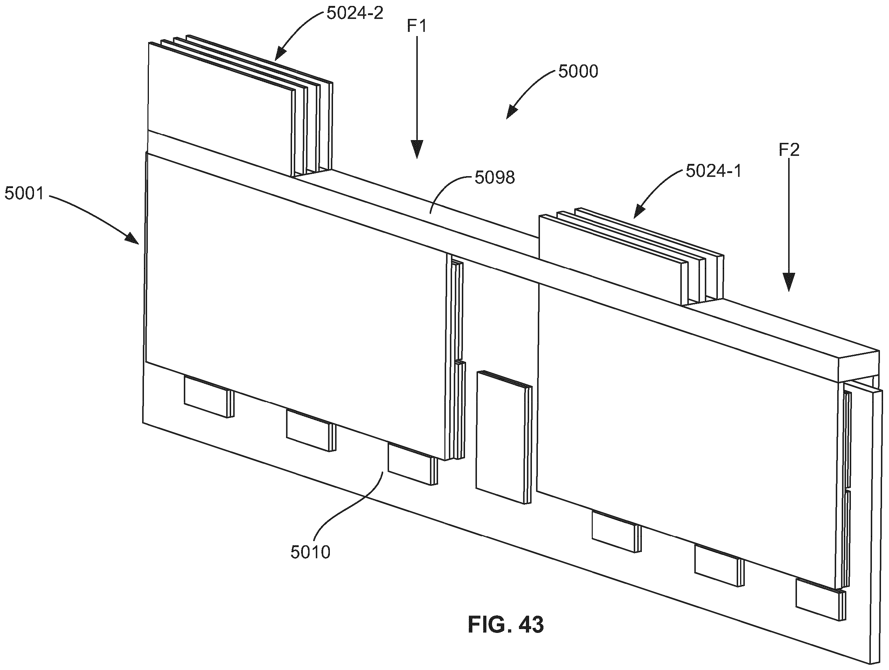

FIGS. 41-43 illustrate another in-line memory module system 5000 and components. With reference first to FIG. 43, system 5000 is shown that includes an in-line memory module, such as DIMM 5010 and a heatsink 5001. As shown in FIG. 41, heatsink 5001 is similar to heatsinks 4001 previously described herein, except for the configuration of the thermally conductive fins. Heatsink 5001 may include two sets of fins extending away from base 5098 of heatsink 5001: first set of fins 5024-1 and second set of fins 5024-2.

First set of fins 5024-1 and second set of fins 5024-2 may differ from one another. In one example, the number of fins in first and second sets of fins 5024-1 and 5024-2 may differ. For example, first set of fins 5024-1 includes three conductive fins: 5024-1a, 5024-1b, 5024-1c. Second set of fins 5024-2 may include more fins than first set of fins 5024-1, and in this example, includes four conductive fins: 5024-2a, 5024-2b, 5024-2c, 5024-2d. In such example, second set of fins 5024-2 includes more fins than first set of fins 5024-1. To allow for the presence of more conductive fins in second set, fin thickness FT2 of second set of fins 5024-2 may be less than the fin thickness FT1 of first set of fins 5024-1.

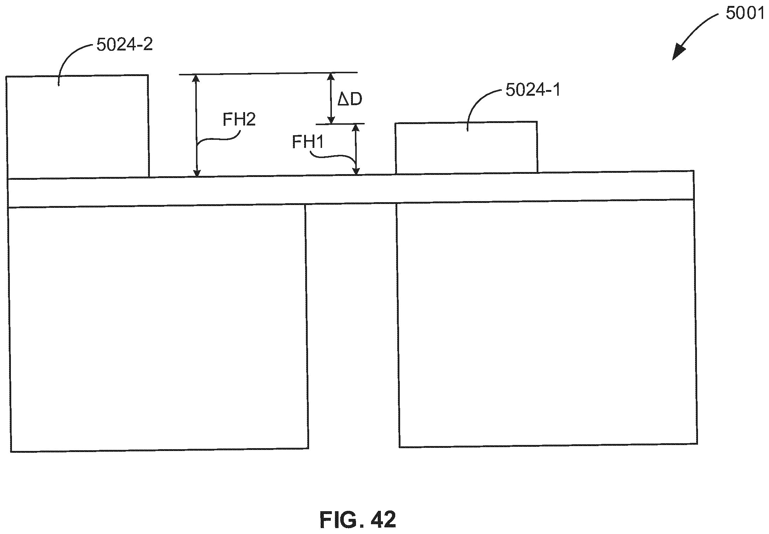

First set of fins 5024-1 and second set of fins 5024-2 may additionally or alternatively differ in height. As shown in FIG. 42, second set of fins 5024-2 that is greater than first height FH1 of fins 5024-2, such that there is a difference ΔD in height between FH2 and FH1. The difference ΔD can vary depending on the application for which the heat spreader is intended to be used.

Although first and second sets of fins 5024-1, 5024-2 differ in number of fins, height of fins, and thickness of fins, in other examples, they may differ only in height, only in the number of fins, or only in thickness, or vary based on another characteristics or other combinations. In still other examples, first and second sets of fins 5024-1, 5024-2 do not differ and may be identical.

With reference back to FIG. 43, first and second sets of fins 5024-1, 5024-2 may be spaced apart from another along length BL2 of base 5098. This can provide a first area A1 and a second area A2 along base 5098 for a user to apply a downward force F1, F2 onto base 5098 to facilitate insertion of system 5000 onto a main board or motherboard.

Aspects of the disclosed technology may be embodied in a method, process, apparatus, or system. According to an aspect of the disclosure, a system is disclosed for cooling a plurality of in-line memory modules includes a heatsink and sliding thermal interface material ("TIM") pads. The heat sink includes a base, plurality of thermally conductive fin and a plurality of pedestals. The plurality of thermally conductive fins extend in a first direction away from the base. The plurality of pedestals extending in a second direction away from the base and opposite the first direction. The sliding TIM pads may be positioned between each of the plurality of pedestals and an adjacent in-line memory module. The sliding TIM pads provide thermal connections between the plurality of pedestals and an adj acent in-line memory module when the plurality of pedestals contact the sliding TIM pads. The plurality of pedestals further include a first leg and a second leg. The first leg and the second leg may be configured to move between a first position and a second position. In the first position, the first and second legs contact sliding TIM pads. In the second position, the first and second legs are spaced apart from sliding TIM pads and do not contact pads; and/or
the first position comprises an expanded position where first and second legs are biased apart from one another, and a second position where first and second legs are compressed together; and/or
the heatsink further comprises a biasing element disposed between the first and second legs of the pedestals, the biasing element biasing first and second legs apart from one another; and/or
the pedestals have a first end adjacent the base and an opposed second end, the second end having an edge surface that is planar; and/or
the plurality of pedestals have a first end adjacent the base and an opposed second end, the second end having an edge surface that is non-planar; and/or
the edge surface is rounded; and/or
the plurality of pedestals are positioned between each of the in-line memory modules; and/or
the heatsink is a monolithic structure, such that the plurality of fins, the base, and the pedestals form a unitary structure; and/or
the system further includes an air distribution system, wherein the air distribution system includes a fan for distributing air exiting the in-line memory module; and/or
the air distribution system further comprises a sloped ramp; and/or
a printed circuit board ("PCB") has a major surface and the heatsink is coupled to the PCB and extends in a direction away from the major surface. The plurality of pedestals extend longitudinally in a direction parallel to the major surface of the main board. Each of the pedestals extend in a direction toward the PCB; and/or
the system further includes a plurality of dual in-line memory modules ("DIMMs") and an air distribution system. The air distribution system further includes a ramp, a fan, and a plurality of baffles. The ramp may be positioned adjacent the plurality of DIMMs. The fan may overlie a top surface of the ramp and the plurality of thermally conductive fins, such that the fan extends between the ramp and the thermally conductive fins. The plurality of baffles may be coupled to the fan. The plurality of baffles direct air flowing from the ramp into the fan; and/or
the plurality of fins have a length extending longitudinally in a direction parallel to a major surface of a system printed circuit board ("PCB"), and a first end and a second end, wherein the ramp is positioned adjacent the second end, and air flows through the fins from the first end to the second end; and/or
the system further comprises an in-line memory module that includes a printed circuit board ("PCB") having a first surface configured to receive a plurality of integrated circuit ("IC") chips. The PCB has a first row, a second row overlying the first row, and a third row overlying the first and second rows. A first plurality of chips are arranged in a first row. A second plurality of chips are arranged in the third row, such that the first and second plurality of chips are spaced apart from one another by the second row; and/or
the system further comprises an in-line memory module includes a printed circuit board having a first surface configured to receive a plurality of integrated circuit ("IC") chips. The PCB further includes a first row, a second row overlying the first row, and a third row overlying the first and second rows. A first plurality of chips arranged in a first row. A second plurality of chips are arranged in a second row. A third plurality of chips are arranged in a second row. A fourth plurality of chips are arranged in a fourth row. The first plurality of chips and the third plurality of chips are aligned with one another. The second plurality of chips and the fourth plurality of chips are aligned with one another.

According to another aspect of the disclosure, a system for cooling a plurality of in-line memory modules includes a heatsink and sliding thermal interface material ("TIM") pads. The heat sink further includes a base and a plurality of thermally conductive fins. The plurality of thermally conductive fins extend in a first direction away from the base. The plurality of pedestals extend in a second direction away from the base and opposite the first direction. The sliding TIM pads may be positioned between each of the plurality of pedestals and an adjacent in-line memory module. The sliding TIM can provide thermal connections between the plurality of pedestals and an adjacent in-line memory module when the plurality of pedestals contact the sliding TIM pads. The plurality of pedestals have end surfaces comprising a non-planar shape; and/or
the end surfaces comprise a rounded shape; and/or
the system further comprises an in-line memory module that includes a printed circuit board ("PCB") having a first surface configured to receive a plurality of integrated circuit ("IC") chips. The PCB has a first row, a second row overlying the first row, and a third row overlying the first and second rows. A first plurality of chips are arranged in a first row. A second plurality of chips are arranged in the third row, such that the first and second plurality of chips are spaced apart from one another by the second row.; and/or
the system further comprises an in-line memory module includes a printed circuit board having a first surface configured to receive a plurality of integrated circuit ("IC") chips. The PCB further includes a first row, a second row overlying the first row, and a third row overlying the first and second rows. A first plurality of chips arranged in a first row. A second plurality of chips are arranged in a second row. A third plurality of chips are arranged in a second row. A fourth plurality of chips are arranged in a fourth row. The first plurality of chips and the third plurality of chips are aligned with one another. The second plurality of chips and the fourth plurality of chips are aligned with one another.

According to another aspect of the disclosure, an in-line memory module includes a printed circuit board ("PCB") having a first surface configured to receive a plurality of integrated circuit ("IC") chips. The PCB has a first row, a second row overlying the first row, and a third row overlying the first and second rows. A first plurality of chips are arranged in a first row. A second plurality of chips are arranged in the third row, such that the first and second plurality of chips are spaced apart from one another by the second row; and/or
the first plurality of chips and the second plurality of chips are aligned with one another; and/or
the first plurality of chips and the second plurality of chips do not align with one another; and/or
the module has form factor of 2U; and/or
the PCB has a first width and a second width that is less than the first width, wherein the first and second plurality of chips are arranged on a portion of the PCB having a first width; and/or
the PCB has a first width and a second width that is less than the first width, wherein at least some of the first plurality of chips are arranged on a first portion of the PCB having a first width and at least some of the second plurality of chips are arranged on a second portion of the PCB having a second width.

According to another aspect of the disclosure, an in-line memory module includes a printed circuit board having a first surface configured to receive a plurality of integrated circuit ("IC") chips. The PCB further includes a first row, a second row overlying the first row, and a third row overlying the first and second rows. A first plurality of chips arranged in a first row. A second plurality of chips are arranged in a second row. A third plurality of chips are arranged in a third row. A fourth plurality of chips are arranged in a fourth row. The first plurality of chips and the third plurality of chips are aligned with one another. The second plurality of chips and the fourth plurality of chips are aligned with one another; and/or
the PCB has a first width and a second width that is less than the first width. At least some of the first plurality of chips are arranged on a first portion of the PCB having a first width and others of the first plurality of chips are arranged on a second portion of the PCB having a second width.

As previously disclosed, aspects of the disclosed technology may be embodied in a method, process, apparatus, or system. Those examples may include one or more of the following features (*e.g.,* F1 through F75):
[F1] A heatsink for a plurality of in-line memory modules comprising: a base; a plurality of thermally conductive fins extending in a first direction away from the base; a plurality of thermally conductive pedestals extending in a second direction away from the base and opposite the first direction, at least some of the plurality of thermally conductive pedestals comprising a first leg and a second leg, each of the at least some of the plurality of thermally conductive pedestals positioned in a space between adjacent in-line memory modules of the plurality of in-line memory modules and configured to move between a first position and a second position; and sliding thermal interface material ("TIM") pads positioned between each pedestal of the at least some of the plurality of thermally conductive pedestals and a directly adjacent in-line memory module, wherein when the at least some of the plurality of thermally conductive pedestals are in the first position, each of the first and second legs contact the sliding TIM pads, such that the sliding TIM pads thermally couple each of the at least some of the plurality of thermally conductive pedestals to the directly adjacent in-line memory module, and wherein when the at least some of the plurality of thermally conductive pedestals are in the second position, the first and second legs of each of the plurality of the at least some of the thermally conductive pedestals are spaced apart from adjacent sliding TIM pads, so as to create gaps between the sliding TIM pads and the at least some of the plurality of thermally conductive pedestals.
[F2] The heatsink of F1, wherein the first position comprises an expanded position wherein the first and second legs are spaced apart from one another, and the second position comprises a compressed position wherein the first and second legs are compressed together.
[F3] The heatsink of F2, wherein the first and second legs are comprised of a resilient material configured to allow for movement of the first and second legs from the first position to the second position.
[F4] The heatsink of F2, wherein the heatsink further comprises a biasing element disposed between each of the first and second legs of the at least some of the plurality of thermally conductive pedestals, the biasing element biasing the first and second legs apart from one another.
[F5] The heatsink of F4, wherein the biasing element is a pre-loaded spring.
[F6] The heatsink of F1, wherein the at least some of the plurality of thermally conductive pedestals have a first end adjacent the base and an opposed second end, the opposed second end having an edge surface that is non-planar, and wherein other thermally conductive pedestals of the plurality of thermally conductive pedestals comprise a single leg, wherein at least one surface of the single leg is configured to contact one of the sliding TIM pads positioned directly adjacent the at least one surface of the single leg.
[F7] The heatsink of F1, wherein the heatsink further comprises a monolithic structure, such that the plurality of thermally conductive fins, the base, and the at least some of the plurality of thermally conductive pedestals collectively comprise the monolithic structure.
[F8] A system comprising: the heatsink of F1; and the plurality of in-line memory modules ("IMMs"), each of the plurality of IMMs further comprising a printed circuit board ("PCB") and a plurality of integrated circuit ("IC") chips mounted to a surface of the PCB.
[F9] The system of F8, wherein each of the plurality of IMMs further comprise a plurality of dual IMMs ("DIMMs") and at least some of the plurality of IC chips comprise a plurality of DRAM chips.
[F10] The system of F8, further comprising a main printed circuit board ("main PCB"), wherein each of the plurality of IMMs are mounted to the PCB, each of the at least some of the plurality of thermally conductive pedestals extending in a direction transverse to a major surface of the main PCB and parallel to major surfaces of each PCB of each of the plurality of IMMs.
[F11] The system of F10, wherein when in the first position, the first leg of each of the at least some of the plurality of pedestals is thermally coupled to the sliding TIM pad positioned between the first leg and an IMM of the plurality of IMMs directly adjacent the first leg, and the second leg of each of the at least some of the plurality of pedestals is thermally coupled to the sliding TIM pad positioned between the second leg and an IMM of the plurality of IMMS directly adjacent the second leg
[F12] The system of F11, wherein the plurality of thermally conductive fins have a first inflow end, a second outflow end, and an elongated length extending parallel to a major surface of the main PCB, such that air flows through the plurality thermally conductive fins between the first inflow end and the second outflow end.
[F13] The system of F8, the system further comprising an air distribution system, wherein the air distribution system further comprises a fan assembly for distributing air exiting the plurality of IMMs.
[F14] The system of F13, further comprising a main PCB ("main PCB"), wherein each of the in-line memory modules are mounted to the main PCB, wherein the plurality of thermally conductive fins have a first inflow end, a second outflow end, and an elongated length extending parallel to a major surface of the main PCB, and wherein the fan assembly is positioned adjacent the second outflow end and is configured to distribute air exiting the second outflow end.
[F15] A system for cooling a plurality of in-line memory modules comprising: a heatsink comprising: a base; a plurality of thermally conductive fins extending in a first direction away from the base; a plurality of thermally conductive pedestals extending in a second direction away from the base and opposite the first direction; and sliding thermal interface material ("TIM") pads positioned between each of the plurality of thermally conductive pedestals and an adjacent in-line memory module, the sliding TIM pads thermally coupling the plurality of thermally conductive pedestals and an adjacent in-line memory module of the plurality of in-line memory modules.
[F16] The system of F15, further comprising the plurality of in-line memory modules ("IMMs"), wherein each of the plurality of IMMs further a printed circuit board ("PCB") and a plurality of integrated circuit ("IC") chips mounted to the PCB.
[F17] The system of F16, wherein the plurality of in-line memory modules further comprise a plurality of dual in-line memory modules ("DIMMs").
[F18] The system of F16, wherein the base and the plurality of thermally conductive pedestals further comprise a vapor chamber, and wherein the plurality of thermally conductive pedestals are configured to transfer heat from the plurality of IC chips to the vapor chamber.
[F19] The system of F18, wherein the vapor chamber is hermetically sealed, and the base further comprises wicking material disposed along at least a surface of the vapor chamber.
[F20] The system of F17, wherein each PCB of the plurality of DIMMs further comprises a surface having a first row, a second row overlying the first row, and a third row overlying the first and second rows, wherein the plurality of IC chips further comprise a first plurality of DRAM chips and a second plurality of DRAM chips, wherein the first plurality of DRAM chips are arranged in the first row and the second plurality of DRAM chips are arranged in the third row, such that the first and second plurality of DRAM chips are spaced apart from one another by the second row, and wherein a height of the second row is at least a same height as a DRAM chip of the first plurality of DRAM chips.
[F21] An in-line memory module comprising: a printed circuit board ("PCB") having a first surface having a first row, a second row overlying the first row, and a third row overlying the first and second rows; a first plurality of integrated circuit ("IC") chips arranged in the first row; a second plurality of IC chips arranged in the third row, such that the first and second plurality of IC chips are spaced apart from one another by the second row, wherein a size of the second row is at least a same size as an IC chip of the first plurality of IC chips.
[F22] The in-line memory module of F21, wherein the first plurality of IC chips and the second plurality of IC chips are aligned with one another.
[F23] The in-line memory module of F21, wherein the first plurality of IC chips and the second plurality of IC chips do not align with one another.
[F24] The in-line memory module of F21, wherein the in-line memory module has a form factor of 2U.
[F25] The in-line memory module of F21, wherein the PCB has a first width and a second width that is less than the first width, wherein the first and second plurality of IC chips are mounted to a portion of the PCB having a first width.
[F26] The in-line memory module of F21, wherein the first and second plurality of IC chips are DRAM chips.
[F27] A system comprising: The in-line memory module of F21, wherein the PCB further comprises a heatsink embedded within the PCB.
[F28] A system comprising: The in-line memory module of F27, wherein the PCB further comprises a top edge and the heatsink comprises a top edge, the top edge of the heatsink spaced apart from the top edge of the PCB.
[F29] The in-line memory module of F27, wherein the PCB comprises a top edge and the heatsink comprises a top edge, the top edge of the heatsink being aligned with the top edge of the PCB.
[F30] An in-line memory module comprising: a printed circuit board ("PCB") having a first surface configured to receive a plurality of integrated circuit ("IC") chips, the PCB having a first row, a second row overlying the first row, and a third row overlying the first and second rows; a first plurality of IC chips arranged in a first row; a second plurality of IC chips arranged in a second row; a third plurality of IC chips arranged in a third row; and a fourth plurality of IC chips arranged in a fourth row, wherein the first plurality of IC chips and the third plurality of IC chips are aligned with one another, and wherein the second plurality of IC chips and the fourth plurality of IC chips are aligned with one another.
[F31] A system comprising: the in-line memory module of any one of F21-F30; and a heatsink coupled to the in-line memory module and being positioned adjacent at least one side of the in-line memory module.
[F32] The system of F31, wherein the heatsink further comprises: a main body having an elongated top edge; and a thermally conductive fin comprising a fin body extending in a direction away from the elongated top edge and a plurality of passageways extending along the fin body, the fin body having a fin width that extends in a first direction parallel to the elongated top edge and a fin length extending in a second direction perpendicular to the first direction, the thermally conductive fin further comprising a plurality of passageways arranged along the fin body, each of the plurality of passageways having a passageway length extending across the fin width.
[F33] The system of F32, wherein the plurality of passageways are integrally formed as part of the thermally conductive fin.
[F34] The system of F32, wherein the heat sink further comprises a fin body having a support surface and a passageway assembly coupled to the support surface, the passageway assembly further comprising the plurality of passageways and a housing enclosing a portion of the plurality of passageways.
[F35] The system of any one of F32-F34, wherein the passageways further comprise a cross-section that is rectangular in shape.
[F36] The system of any one of F32-F34 wherein the passageways each have a cross-section that is square in shape.
[F37] The system of any one of F34-F36, wherein the passageway assembly further comprises a plurality of divider panels segregating an interior of the housing into the plurality of passageways, wherein the divider panels comprises either a top wall or a bottom wall for each of the passageways, and wherein each passageway comprises a top wall, a bottom wall, and opposed front and rear walls, wherein the top and bottom walls are formed from the divider panels, such that the divider panel has a top surface forming a bottom surface of a passageway and a bottom surface forming a top surface of the passageway.
[F38] The system of F31, wherein the heatsink further comprises: a main body having an elongated top edge; and a thermally conductive fin comprising a fin body extending in a direction away from the elongated top edge and a plurality of passageways extending along the fin body, the fin body having a fin width that extends in a first direction parallel to the top edge and a fin length extending in a second direction perpendicular to the first direction, the thermally conductive fin further comprising a passageway having a passageway length extending across a portion of the fin width, and wherein the plurality of passageways comprise recessed areas of the fin body.
[F39] The system of F38, wherein each of the plurality of passageways of the heatsink comprises a protrusion having first and second angled portions and a third planar portion connecting the first and second angled portions.
[F40] The system of F31 wherein the heatsink further comprises: a base comprising an elongated main body having opposed outermost edges; a plurality of thermally conductive fins extending upwardly from the base; and at least two conductive panels extending downwardly from the base, the at least two conductive panels spaced apart from one another, and wherein the plurality of thermally conductive fins are positioned adjacent one of the opposed outermost edges.
[F41] The system of F40, wherein the plurality of thermally conductive fins comprise at least three conductive fins.
**[F42]** The system of F40, wherein the plurality of thermally conductive fins comprise at least four conductive fins.
**[F43]** The system of any one of F40-F42, wherein the plurality of thermally conductive fins is a first plurality of thermally conductive fins and the heatsink further comprises a second plurality of thermally conductive fins spaced apart from the first plurality of thermally conductive fins.
**[F44]** The system of F43, wherein the second plurality of thermally conductive fins are adjacent an other end of the opposed outermost edges.
**[F45]** The system of F43, wherein the first and second plurality of thermally conductive fins structurally differ.
**[F46]** The system of any one of F43-F45, wherein a first number of fins in the first plurality of thermally conductive fins is greater than a second number of fins in the second plurality of thermally conductive fins.
**[F47]** The system of any one of F43-F46, wherein a first height of the first plurality of thermally conductive fins is greater than a second height of the second plurality of thermally conductive fins.
**[F48]** The system of any one of F43-F44, wherein the first and second plurality of thermally conductive fins have the same structural configuration.
**[F49]** The system of F48, wherein the first and second plurality of thermally conductive fins have the same number of conductive fins.
**[F50]** The system of any one of F48-F49, wherein the first and second plurality of thermally conductive fins have the same height.
**[F51]** A heatsink for an in-line memory module comprising: a main body having an elongated top edge; and a thermally conductive fin comprising a fin body extending in a direction away from the top edge and a plurality of passageways extending along the fin body, the fin body having a fin width that extends in a first direction parallel to the top edge and a fin length extending in a second direction perpendicular to the first direction, the fin further comprising a plurality of passageways arranged along the fin body, each of the plurality of passageways having a passageway length extending across the fin width.
**[F52]** The heatsink of F51, wherein the plurality of passageways are integrally formed as part of the conductive fin.
**[F53]** The heatsink of F51, wherein the fin body further comprises a support surface and a passageway assembly coupled to the support surface, the passageway assembly further comprising the plurality of passageways and a housing enclosing a portion of the plurality of passageways.
**[F54]** The heatsink of F51, wherein the passageways each have a cross-section that is rectangular in shape.
**[F55]** The heatsink of F51, wherein the passageways each have a cross-section that is square in shape.
**[F56]** The heatsink of F53, wherein the passageway assembly further comprises a plurality of divider panels segregating an interior of the housing into the plurality of passageways, wherein the divider panels comprises either a top wall or a bottom wall for each of the passageways, and wherein each passageway comprises a top wall, a bottom wall, and opposed front and rear walls, wherein the top and bottom walls are formed from the divider panels, such that the divider panel has a top surface forming a bottom surface of a passageway and a bottom surface forming a top surface of the passageway.
**[F57]** The heatsink of F51, wherein the plurality of passageways comprise recessed areas on the fin body.
[F58] The heatsink of F57, wherein each of the plurality of passageways comprises a protrusion having first and second angled portions and a third planar portion connecting the first and second angled portions.
[F59] A system for thermal management of an in-line memory module comprising: an in-line memory module; and a first heatsink and a second heatsink interlocked with one another around at least a portion of the in-line memory module, the first and second heatsinks each comprising: a main body having an elongated top edge and an interlocking feature; and a thermally conductive fin comprising a fin body extending in a direction away from the top edge and a plurality of passageways extending along the fin body, the fin body having a fin width that extends in a first direction parallel to the top edge and a fin length extending in a second direction perpendicular to the first direction, wherein the fin further comprising a plurality of passageways arranged along the fin body, the plurality of passageways arranged vertically along the fin length, and each of the plurality of passageways having a passageway length extending across the fin width, wherein the interlocking feature of the first heatsink interlocks with the interlocking feature of the second heatsink so as to inhibit movement of the first and second heatsinks away from one another.
[F60] The system of F59, wherein the interlocking feature of the first and second heatsinks are tabs extending in a direction perpendicular to a major surface of the main body, and wherein when joined together, the tabs of the first heatsink interlock with tabs of the second heatsink, so as to inhibit movement of the first and second heatsinks in a vertical direction.
[F61] The system of F60, wherein the interlocking feature of the first and second heatsinks further comprise ledges extending in a direction perpendicular to a major surface of the main body and along the top edge, wherein ledges of the first heatsink are disposed between ledges of the second heatsinks so as to inhibit movement of the first and second heatsinks in a lateral direction along the top edge.
[F62] A heatsink for an in-line memory module, comprising: a base comprising an elongated main body having opposed outermost edges; a plurality of thermally conductive fins extending upwardly from the base; and at least two conductive panels extending downwardly from the base, the at least two conductive panels spaced apart from one another, and wherein the conductive fins are positioned adjacent one of the opposed outermost edges.
[F63] The heatsink of F62, wherein the plurality of conductive fins comprise at least three conductive fins.
[F64] The heatsink of F62, wherein the plurality of conductive fins comprise at least four conductive fins.
[F65] The heatsink of F63, wherein the plurality of conductive fins is a first plurality of conductive fins and the heatsink further comprises a second plurality of conductive fins spaced apart from the first plurality of conductive fins.
[F66] The heatsink of F65, wherein the second plurality of conductive fins are adjacent an other of the opposed second end.
[F67] The heatsink of F65, wherein the first and second plurality of conductive fins structurally differ.
[F68] The heatsink of F67, wherein a first number of fins in the first plurality of conductive fins is greater than a second number of fins in the second plurality of conductive fins.
[F69] The heatsink of F68, wherein a first height of the first plurality of conductive fins is greater than a second height of the second plurality of conductive fins.
[F70] The heatsink of F65, wherein the first and second plurality of conductive fins have the same structural configuration.
[F71] The heatsink of F70, wherein the first and second plurality of conductive fins have the same number of conductive fins.
[F72] The heatsink of F71, wherein the first and second plurality of conductive fins have the same height.
[F73] The heatsink of F62, wherein the conductive fins extend along a majority of the length of the elongated main body.
[F74] The heatsink of F73, wherein the conductive fins extend along an entire length of the elongated main body.
[F75] The heatsink of F73, wherein a first height of at least one of the plurality of conductive fins differs from a second height of at least an other of the plurality of conductive fins.

Unless otherwise stated, the foregoing alternative examples are not mutually exclusive, but may be implemented in various combinations to achieve unique advantages. As these and other variations and combinations of the features discussed above can be utilized without departing from the subject matter defined by the claims, the foregoing description should be taken by way of illustration rather than by way of limitation of the subject matter defined by the claims. For example, it is to be appreciated that although reference was often made to a DIMM, any type of in-line memory module can be provided herein, including a SIMM. Similarly, the discussion of the features of one heatsink or features of a heatsink in one embodiment are equally applicable to the heatsink in the same or different embodiment. Furthermore, the discussion of one or more features in one embodiment or example are to be understood as being equally applicable to similar features in another embodiment or example and/or can be combined with one or more features from another embodiment. In addition, the provision of the examples described herein, as well as clauses phrased as "such as," "including," and the like, should not be interpreted as limiting the subject matter of the claims to the specific examples; rather, the examples are intended to illustrate only one of many possible implementations. Further, the same or similar reference numbers in different drawings can identify the same or similar elements.

## Claims

1. A heatsink for a plurality of in-line memory modules comprising:
a base;
a plurality of thermally conductive fins extending in a first direction away from the base;
a plurality of thermally conductive pedestals extending in a second direction away from the base and opposite the first direction, at least some of the plurality of thermally conductive pedestals comprising a first leg and a second leg, each of the at least some of the plurality of thermally conductive pedestals positioned in a space between adjacent in-line memory modules, IMMs, of the plurality of in-line memory modules and configured to move between a first position and a second position; and
sliding thermal interface material, TIM, pads positioned between each pedestal of the at least some of the plurality of thermally conductive pedestals and a directly adjacent in-line memory module,
wherein when the at least some of the plurality of thermally conductive pedestals are in the first position, each of the first and second legs contact the sliding TIM pads, such that the sliding TIM pads thermally couple each of the at least some of the plurality of thermally conductive pedestals to the directly adjacent in-line memory module, and
wherein when the at least some of the plurality of thermally conductive pedestals are in the second position, the first and second legs of each of the plurality of the at least some of the thermally conductive pedestals are spaced apart from adjacent sliding TIM pads, so as to create gaps between the sliding TIM pads and the at least some of the plurality of thermally conductive pedestals.

2. The heatsink of claim 1, wherein the first position comprises an expanded position wherein the first and second legs are spaced apart from one another, and the second position comprises a compressed position wherein the first and second legs are compressed together.

3. The heatsink of claim 2, wherein the first and second legs are comprised of a resilient material configured to allow for movement of the first and second legs from the first position to the second position.

4. The heatsink of claim 2 or claim 3, wherein the heatsink further comprises a biasing element disposed between each of the first and second legs of the at least some of the plurality of thermally conductive pedestals, the biasing element biasing the first and second legs apart from one another; and
wherein optionally the biasing element is a pre-loaded spring.

5. The heatsink of any one of claims 1 to 4, wherein the at least some of the plurality of thermally conductive pedestals have a first end adjacent the base and an opposed second end, the opposed second end having an edge surface that is non-planar, and wherein other thermally conductive pedestals of the plurality of thermally conductive pedestals comprise a single leg, wherein at least one surface of the single leg is configured to contact one of the sliding TIM pads positioned directly adjacent the at least one surface of the single leg.

6. The heatsink of any one of claims 1 to 5, wherein the heatsink further comprises a monolithic structure, such that the plurality of thermally conductive fins, the base, and the at least some of the plurality of thermally conductive pedestals collectively comprise the monolithic structure.

7. A system comprising:
the heatsink of any one claims 1 to 6; and
the plurality of IMMs, each of the plurality of IMMs further comprising a printed circuit board, PCB, and a plurality of integrated circuit, IC, chips mounted to a surface of the PCB; and
wherein optionally each of the plurality of IMMs further comprise a plurality of dual IMMs, DIMMs, and at least some of the plurality of IC chips comprise a plurality of DRAM chips.

8. The system of claim 7, further comprising a main printed circuit board, main PCB, wherein each of the plurality of IMMs are mounted to the PCB, each of the at least some of the plurality of thermally conductive pedestals extending in a direction transverse to a major surface of the main PCB and parallel to major surfaces of each PCB of each of the plurality of IMMs.

9. The system of claim 8, wherein when in the first position,
the first leg of each of the at least some of the plurality of pedestals is thermally coupled to the sliding TIM pad positioned between the first leg and an IMM of the plurality of IMMs directly adjacent the first leg, and
the second leg of each of the at least some of the plurality of pedestals is thermally coupled to the sliding TIM pad positioned between the second leg and an IMM of the plurality of IMMS directly adjacent the second leg; and/or
wherein the plurality of thermally conductive fins have a first inflow end, a second outflow end, and an elongated length extending parallel to a major surface of the main PCB, such that air flows through the plurality thermally conductive fins between the first inflow end and the second outflow end.

10. The system of any one of claims 7 to 9, the system further comprising an air distribution system, wherein the air distribution system further comprises a fan assembly for distributing air exiting the plurality of IMMs; and/or
wherein the system further comprising a main PCB, main PCB, wherein each of the in-line memory modules are mounted to the main PCB,
wherein the plurality of thermally conductive fins have a first inflow end, a second outflow end, and an elongated length extending parallel to a major surface of the main PCB, and
wherein the fan assembly is positioned adjacent the second outflow end and is configured to distribute air exiting the second outflow end.

11. A system for cooling a plurality of in-line memory modules comprising:
a heatsink comprising:
a base;
a plurality of thermally conductive fins extending in a first direction away from the base;
a plurality of thermally conductive pedestals extending in a second direction away from the base and opposite the first direction; and
sliding thermal interface material, TIM, pads positioned between each of the plurality of thermally conductive pedestals and an adj acent in-line memory module, the sliding TIM pads thermally coupling the plurality of thermally conductive pedestals and an adjacent in-line memory module of the plurality of in-line memory modules.

12. The system of claim 11, further comprising the plurality of in-line memory modules, IMMs, wherein each of the plurality of IMMs further comprises a printed circuit board, PCB, and a plurality of integrated circuit, IC, chips mounted to the PCB; and
wherein optionally the plurality of in-line memory modules further comprise a plurality of dual in-line memory modules, DIMMs.

13. The system of claim 12, wherein the base and the plurality of thermally conductive pedestals further comprise a vapor chamber, and wherein the plurality of thermally conductive pedestals are configured to transfer heat from the plurality of IC chips to the vapor chamber.

14. The system of claim 13, wherein the vapor chamber is hermetically sealed, and the base further comprises wicking material disposed along at least a surface of the vapor chamber.

15. The system of any one of claims 12 to 14,
wherein each PCB of the plurality of DIMMs further comprises a surface having a first row, a second row overlying the first row, and a third row overlying the first and second rows,
wherein the plurality of IC chips further comprise a first plurality of DRAM chips and a second plurality of DRAM chips,
wherein the first plurality of DRAM chips are arranged in the first row and the second plurality of DRAM chips are arranged in the third row, such that the first and second plurality of DRAM chips are spaced apart from one another by the second row, and
wherein a height of the second row is at least a same height as a DRAM chip of the first plurality of DRAM chips.
